# FASCICULE DE BREVET EUROPEEN

(11) **EP 4 352 276 B1**
(45) Date de publication et mention de la délivrance du brevet: **04.06.2025**
(21) Numéro de dépôt: 22723129.7
(22) Date de dépôt: 15.04.2022
(51) Int. Cl.: C23C 16/448, C23C 16/52, C23C 16/455, B01D 1/00, B01D 7/00, H01L 21/67

(54) **DISPOSITIF ET PROCÉDÉ DE DISTRIBUTION D'UNE PHASE GAZEUSE D'UN PRÉCURSEUR SOLIDE**
VORRICHTUNG UND VERFAHREN ZUR ABGABE EINER GASPHASE EINES FESTEN VORLÄUFERS
DEVICE AND METHOD FOR DISPENSING A GAS PHASE OF A SOLID PRECURSOR

(30) Priorité: 07.06.2021 FR 2105994
(43) Date de publication de la demande: 17.04.2024
(73) Titulaire: Air Liquide Electronics Systems, 75007 Paris (FR)
(72) Inventeur: PLAZA, Sonia, 38130 Echirolles (FR); TODOROVA, Vanina, 38130 Echirolles (FR); DULPHY, Hervé, 38130 Echirolles (FR); LAURENT, Valere, 38130 Echirolles (FR)
(74) Mandataire: Air Liquide
(86) Numéro de dépôt international: PCT/EP2022/060165
(87) Numéro de publication internationale: WO 2022/258247

(56) Documents cités:
- EP-A1- 0 382 987
- WO-A1-2014/170503
- US-A1- 2011 027 457
- US-A1- 2019 177 840

## Description

La présente invention concerne un dispositif de distribution d'une phase gazeuse d'un précurseur solide destinée à être utilisée dans une installation de traitement. L'invention porte également sur un procédé de distribution d'une phase gazeuse d'un précurseur solide mettant en œuvre un tel dispositif ainsi qu'une installation de traitement comprenant ledit dispositif.

L'invention peut s'appliquer à la distribution de précurseurs dans différents procédés de traitement tels que la gravure ou le nettoyage de substrats, le dépôt de revêtements ou de couches minces. L'invention trouve notamment application dans l'industrie des semi-conducteurs, le précurseur pouvant par exemple intervenir dans la production de couches minces ou le dopage de substrats lors de la fabrication de composants électroniques ou de circuits intégrés.

En particulier, le dispositif selon l'invention est destiné à fournir une phase gazeuse d'un précurseur à une installation de dépôt chimique en phase vapeur. Le précurseur peut être distribué pur ou dilué dans un gaz porteur.

Lors d'un dépôt chimique en phase vapeur, un substrat est exposé à un ou plusieurs précurseurs en phase gazeuse, qui réagissent et/ou se décomposent à la surface du substrat pour générer le dépôt désiré.

De nombreux matériaux sont susceptibles d'être utilisés comme précurseurs dans des installations de traitement du type dépôt chimique en phase vapeur. Ces précurseurs peuvent se trouver à l'état gazeux, liquide ou solide. Ces trois états fondamentaux sont généralement considérés dans des conditions standard de pression et de température.

Les précurseurs gazeux sont les plus faciles à transporter jusqu'à leur point d'utilisation. En effet, ils sont généralement stockés sous pression dans leur contenant et s'écoulent ainsi naturellement vers un point d'utilisation à plus faible pression.

La distribution de précurseurs à l'état liquide impose plus de contraintes. Une méthode de distribution consiste à soutirer la phase liquide du précurseur de son contenant en y injectant un gaz inerte non miscible qui va pousser le liquide dans un tuyau plongeant. Une autre méthode repose sur un chauffage de la phase liquide pour la vaporiser, la pression et la température de la phase vapeur devant être maintenues jusqu'au point d'utilisation.

De nombreux précurseurs qui présentent des propriétés intéressantes, en particulier pour l'industrie des semi-conducteurs, ne sont disponibles qu'à l'état solide dans des conditions standard de pression et de température. Ces précurseurs peuvent se présenter sous forme de granulés ou de poudre. Toutefois, ils présentent généralement une température de sublimation très élevée et une pression de vapeur saturante à température ambiante très basse, et ne peuvent donc pas être distribués directement vers l'installation de traitement, du fait de la faible quantité de gaz qui serait fournie.

Différentes solutions ont été proposées afin de pouvoir utiliser ces précurseurs solides à l'échelle industrielle. On connaît notamment du document EP-A-2247769 un dispositif de distribution reposant sur la sublimation, c'est-à-dire un passage de l'état solide à l'état gazeux, d'un précurseur solide. Le précurseur est placé dans un récipient qui est chauffé à une température permettant une sublimation du précurseur solide et la génération de vapeurs dudit précurseur. Un gaz vecteur s'écoule à travers le précurseur chauffé dans le récipient et en ressort saturé en vapeurs du précurseur solide pour être distribué jusqu'au point d'utilisation.

Selon les exigences requises par l'installation de traitement, les solutions actuelles peuvent se révéler insuffisantes.

En effet, pour garantir à l'utilisateur la fiabilité et la reproductibilité des procédés de traitement opérés avec le précurseur solide, il est nécessaire de sublimer le précurseur à la température souhaitée et de fournir la phase vapeur du précurseur à l'état saturé et à la pression souhaitée au point d'utilisation, et ce sans contamination. Il existe également un besoin en termes de flexibilité opératoire, le débit distribué au point d'utilisation pouvant varier selon les besoins de l'installation et le procédé de traitement mis en jeu, et les nombreux précurseurs solides à disposition ayant chacun des températures et des pressions de sublimation différentes.

En outre, lorsqu'un gaz vecteur est utilisé pour transporter les vapeurs de précurseur jusqu'au point d'utilisation, la concentration de précurseur dans le gaz vecteur peut être difficile à maîtriser au cours du temps. En effet, lorsque le précurseur solide est sublimé, la forme, la morphologie, la surface de contact avec le gaz vecteur et le volume du précurseur solide changent, modifiant ainsi le débit de vapeurs et donc la concentration de précurseur dans le gaz vecteur. Il est d'autant plus difficile de maintenir une concentration constante de précurseur dans le gaz vecteur que les métrologies permettant la quantification sont difficiles à développer. Afin de pouvoir maintenir une concentration de précurseur constante, il faut saturer le gaz vecteur en précurseur tout au long de l'utilisation du récipient. Certains récipients ont une conception particulière permettant d'atteindre la saturation du gaz vecteur. Lorsque le récipient utilisé a une conception ne permettant pas d'atteindre la saturation du gaz vecteur en précurseur pendant toute la durée d'utilisation du récipient, la proportion de précurseur dans le gaz vecteur diminue au fur et à mesure de l'utilisation du récipient.

Par ailleurs, le contrôle de la température du précurseur sublimé peut poser des difficultés. En effet, la phase gazeuse du précurseur doit être maintenue à une température supérieure ou égale à la température de sublimation sur l'ensemble du trajet depuis le récipient jusqu'au point d'utilisation. La présence de points plus froids sur le trajet du fluide en aval du récipient peut engendrer une cristallisation, i. e. une condensation, de la phase gazeuse au niveau de ces points. Il s'ensuit une variation du débit de précurseur distribué ainsi qu'un colmatage des composants du circuit de distribution de gaz, tels les vannes, les contrôleurs de débit, ... et des restrictions de passage dans les canalisations, ce qui cause des variations de débit supplémentaires et des dysfonctionnements de l'installation.

D'autres dispositifs de distribution d'une phase gazeuse d'un précurseur solide sont également connus de US 2019/177840 A1 et WO 2014/170503 A1.

L'invention a pour but de pallier tout ou partie des inconvénients mentionnés ci-dessus, notamment en proposant un dispositif de distribution d'une phase gazeuse d'un précurseur solide permettant une distribution stable et flexible, en fonction notamment des débits requis au point d'utilisation du précurseur et/ou de la nature du précurseur, indépendamment de la conception du récipient contenant le précurseur, et avec lequel le risque d'une condensation de la phase gazeuse au cours de son acheminement jusqu'au point d'utilisation est grandement réduit, voire éliminé, sans toutefois complexifier de façon excessive le dispositif.

A cette fin, la solution de l'invention est un dispositif de distribution d'une phase gazeuse d'au moins un précurseur solide tel que défini dans la revendication 1, ledit dispositif comprenant :
- un récipient destiné à contenir une phase solide dudit précurseur, le récipient présentant un fond et un sommet,
- un premier moyen de chauffage configuré pour chauffer au moins une partie du récipient et/ou de la phase solide de façon à former une phase gazeuse dudit précurseur dans le récipient,
- des moyens de distribution reliés fluidiquement au récipient et configurés pour distribuer la phase gazeuse depuis le récipient vers un point d'utilisation,

le dispositif comprenant en outre une enceinte ayant un volume interne dans lequel sont agencés le récipient, le premier moyen de chauffage et les moyens de distribution, l'enceinte présentant une direction axiale sensiblement verticale et orientée dans un sens ascendant, le volume interne de l'enceinte comprenant une zone inférieure et une zone supérieure, le dispositif comprenant en outre un deuxième moyen de chauffage configuré pour chauffer au moins une partie du volume interne de l'enceinte, le deuxième moyen de chauffage comprenant un moyen de circulation d'air configuré pour faire circuler de l'air depuis le deuxième moyen de chauffage en direction du volume interne de l'enceinte.

Un tel agencement pour le deuxième moyen de chauffage, permet d'assurer une température homogène à l'intérieur de l'enceinte en maintenant un gradient de température au sein de cette enceinte. Ceci permet d'éviter une condensation de la phase gazeuse pendant son transport jusqu'au point d'utilisation.

Selon le cas, l'invention peut comprendre l'une ou plusieurs des caractéristiques énoncées ci-après.

Le deuxième moyen de chauffage est configuré pour chauffer au moins une partie du volume interne de l'enceinte par convection forcée.

Le deuxième moyen de chauffage est distinct du premier moyen de chauffage.

Le deuxième moyen de chauffage est configuré pour chauffer au moins la moitié du volume interne de l'enceinte, notamment sensiblement tout le volume interne de l'enceinte.

Le deuxième moyen de chauffage est configuré pour générer un profil de température au sein du récipient et des moyens de distribution, ledit profil de température ayant des températures qui augmentent suivant la direction axiale.

La zone supérieure est agencée à un niveau supérieur à celui de la zone inférieure en suivant la direction axiale, le premier récipient et le premier moyen de chauffage étant agencés dans la zone inférieure et le deuxième moyen de chauffage et les moyens de distribution étant agencés dans la zone supérieure.

Le moyen de circulation d'air est agencé dans la zone supérieure.

Le moyen de circulation d'air comprend au moins un ventilateur, un souffleur, une buse ou une turbine.

Le sommet est agencé à un niveau supérieur à celui du fond en suivant la direction axiale.

Le profil de température comprend une première température au niveau des moyens de distribution et une deuxième température au niveau du sommet du récipient, la première température étant supérieure à la deuxième température.

Le deuxième moyen de chauffage est configuré de sorte que le profil de température présente une deuxième température au niveau du sommet du récipient et une troisième température au niveau du fond du récipient, la deuxième température étant supérieure à la troisième température.

Le dispositif comprend un troisième moyen de chauffage agencé dans la zone inférieure de l'enceinte, de préférence autour d'au moins une partie du fond du récipient ou sous le fond du récipient.

Le troisième moyen de chauffage est configuré pour modifier et/ou ajuster le profil de température, en particulier pour augmenter au moins la troisième température.

Le deuxième moyen de chauffage et/ou le troisième moyen de chauffage sont configurés de sorte que la différence entre la première température et la deuxième température est de 1 à 35 °C, en particulier de 1 à 10 °C, et/ou la différence entre la deuxième température et la troisième température est de 2 à 70 °C, en particulier de 2 et 20°C.

Le deuxième moyen de chauffage comprend au moins une résistance électrique notamment montée sur une paroi de l'enceinte ou à proximité de ladite paroi.

Le troisième moyen de chauffage comprend un plateau chauffant sur lequel repose le récipient.

Le dispositif comprend au moins un capteur de pression configuré pour mesurer la pression à l'intérieur du récipient et une unité de commande reliée au capteur de pression et au premier moyen de chauffage, l'unité de commande étant notamment configurée pour réguler et/ou ajuster la puissance de chauffage délivrée par le premier moyen de chauffage en fonction de la pression mesurée par le capteur de pression.

L'unité de commande comprend des moyens de comparaison de la pression dans le récipient avec une pression de consigne prédéterminée, l'unité de commande étant configurée pour réduire la puissance de chauffage, notamment délivrée par le premier moyen de chauffage, lorsque la pression mesurée à l'intérieur du récipient est supérieure ou égale à la pression de consigne et pour augmenter la puissance de chauffage, notamment délivrée par le premier moyen de chauffage, lorsque la pression dans le récipient est inférieure à la pression de consigne prédéterminée.

L'unité de commande est configurée pour réguler et/ou ajuster la puissance de chauffage délivrée par le deuxième moyen de chauffage suivant une première consigne de température prédéterminée et/ou l'unité de commande est configurée pour réguler et/ou ajuster la puissance de chauffage délivrée par le troisième moyen de chauffage suivant une deuxième consigne de température prédéterminée.

Le dispositif comprend une source de gaz porteur, une conduite d'alimentation reliant fluidiquement la source de gaz porteur à une entrée du récipient et des moyens de circulation du gaz porteur dans le récipient, lesdits moyens de circulation du gaz porteur étant configurés pour faire circuler le gaz porteur entre l'entrée et une sortie du récipient de sorte que les moyens de distribution distribue un mélange gazeux comprenant la phase gazeuse et le gaz porteur depuis le récipient, lesdits moyens de circulation du gaz porteur étant notamment configurés pour contrôler le débit de gaz porteur circulant dans le récipient et/ou pour contrôler la pression dans le récipient.

Le premier moyen de chauffage est configuré pour délivrer une puissance de chauffage variable.

Le dispositif comprend au moins un capteur de température configuré pour mesurer la température d'une surface extérieure du récipient et/ou pour mesurer la température à l'intérieur de l'enceinte, et une unité de commande reliée au capteur de température et au premier moyen de chauffage, l'unité de commande étant notamment configurée pour faire varier la puissance de chauffage délivrée par le premier moyen de chauffage en fonction de la température mesurée par le capteur de température.

Le capteur de température est disposé sur la paroi extérieur du récipient ou dans le récipient.

L'unité de commande comprend des moyens de comparaison de la température mesurée par le capteur de température avec une troisième consigne de température, l'unité de commande étant configurée pour réduire la puissance de chauffage lorsque la température mesurée est supérieure à la troisième consigne de température et pour augmenter la puissance de chauffage lorsque la température mesurée est inférieure à la troisième consigne de température.

Les moyens de distribution comprennent au moins une conduite de distribution traversant une première paroi de l'enceinte, un élément chauffant formant un manchon autour d'au moins une partie de la conduite de distribution et s'étendant de part et d'autre de ladite première paroi.

Le manchon comprend au moins deux coquilles ou un cylindre.

Le manchon comprend un matériau conducteur tel que l'aluminium.

Le manchon est configuré pour épouser la conduite de distribution au niveau de la première paroi.

Le manchon comporte au moins une résistance chauffante et au moins une sonde de température, l'ensemble étant notamment agencé pour que la puissance de chauffage de la résistance chauffante du manchon soit asservie à la sonde de température du manchon.

Un tel agencement permet de chauffer la conduite de distribution à proximité de la première paroi pour éviter un point froid.

Le manchon est distinct du premier moyen de chauffage et du deuxième moyen de chauffage.

En outre, l'invention concerne un ensemble de distribution comprenant au moins deux dispositifs de distribution tels que définis ci-dessus, chaque dispositif comprenant une enceinte, un récipient et des moyens de distribution respectifs reliés fluidiquement à une canalisation commune, ledit ensemble comprenant des moyens de basculement configurés pour occuper une première position dans laquelle la phase gazeuse est distribuée dans la canalisation commune à partir de l'un des deux récipients et, lorsque la quantité de précurseur dans le récipient est inférieure ou égale à un seuil bas prédéterminé, pour occuper une deuxième position dans laquelle la phase gazeuse est distribuée dans la canalisation commune à partir de l'autre des deux récipients ou pour occuper une position intermédiaire dans laquelle la phase gazeuse est distribuée à partir des deux récipients simultanément, les moyens de basculement étant reliés à un organe de mesure d'une grandeur physique représentative de la quantité de précurseur dans le récipient choisie parmi : la masse du récipient, la pression dans le récipient, la température d'une surface extérieure du récipient, le déplacement des moyens de basculement de la première position à la deuxième position étant déterminé en fonction de la mesure de ladite grandeur physique.

Les caractéristiques ci-dessus sont applicables prises seules ou en combinaison à cet aspect de l'invention.

Selon un autre aspect, l'invention concerne une installation de traitement, en particulier de dépôt chimique en phase vapeur, comprenant une chambre de traitement dans laquelle un ou plusieurs substrats à traiter sont installés, la chambre de traitement comportant des moyens d'introduction d'au moins une phase gazeuse d'un précurseur solide dans la chambre de traitement, caractérisée en ce que les moyens d'introduction sont reliés fluidiquement aux moyens de distribution d'un dispositif ou d'un ensemble tels que définis ci-dessus.

Les caractéristiques ci-dessus sont applicables prises seules ou en combinaison à cet aspect de l'invention.

En outre, l'invention concerne un procédé de distribution d'une phase gazeuse d'au moins un précurseur solide tel que défini dans la revendication 11 comprenant les étapes suivantes :
a. agencer une phase solide dudit précurseur dans un récipient,
b. chauffer au moins une partie du récipient et/ou de la phase solide avec un premier moyen de chauffage de façon à former une phase gazeuse dudit précurseur dans le récipient,
c. distribuer la phase gazeuse depuis le récipient par des moyens de distribution reliés fluidiquement au récipient, caractérisé en ce que ledit procédé comprend en outre les étapes de :
d. agencer le récipient, le premier moyen de chauffage et les moyens de distribution dans un volume interne d'une enceinte, l'enceinte ayant une direction axiale sensiblement verticale et orientée dans un sens ascendant, le volume interne de l'enceinte comprenant une zone inférieure et une zone supérieure,
e. chauffer au moins une partie du volume interne de l'enceinte avec un deuxième moyen de chauffage, le deuxième moyen de chauffage comprenant un moyen de circulation d'air configuré pour faire circuler de l'air depuis le deuxième moyen de chauffage en direction du volume interne de l'enceinte.

Les caractéristiques ci-dessus sont applicables prises seules ou en combinaison à cet aspect de l'invention.

Selon le cas, cet aspect de l'invention peut comprendre l'une ou plusieurs des caractéristiques énoncées ci-après.

Le deuxième moyen de chauffage est configuré pour générer un profil de température au sein du récipient et des moyens de distribution, ledit profil de température ayant des températures qui augmentent suivant la direction axiale.

Le profil de température comprend une première température au niveau des moyens de distribution et une deuxième température au niveau du sommet du récipient, la première température étant supérieure à la deuxième température.

Le deuxième moyen de chauffage est configuré de sorte que le profil de température présente une deuxième température au niveau du sommet du récipient et une troisième température au niveau du fond du récipient, la deuxième température étant supérieure à la troisième température.

Le procédé comprend l'étape de modifier et/ou ajuster le profil de température, en particulier pour augmenter au moins la troisième température, avec un troisième moyen de chauffage agencé dans la zone inférieure de l'enceinte, de préférence autour d'au moins une partie du fond du récipient ou sous le fond du récipient.

Le deuxième moyen de chauffage et/ou le troisième moyen de chauffage sont configurés de sorte que la différence entre la première température et la deuxième température est de 1 à 35 °C, en particulier de 1 à 10 °C, et/ou la différence entre la deuxième température et la troisième température est de 2 à 70 °C, en particulier de 2 et 20°C.

Le procédé comporte l'étape de réduire la puissance de chauffage, notamment délivrée par le premier moyen de chauffage, lorsque la pression mesurée à l'intérieur du récipient est supérieure ou égale à la pression de consigne et pour augmenter la puissance de chauffage, notamment délivrée par le premier moyen de chauffage, lorsque la pression dans le récipient est inférieure à la pression de consigne prédéterminée, l'unité de commande comprenant des moyens de comparaison de la pression dans le récipient, notamment telle que mesurée par le capteur de pression, avec une pression de consigne prédéterminée.

Le procédé comporte l'étape de réguler et/ou ajuster la puissance de chauffage délivrée par le troisième moyen de chauffage suivant une deuxième consigne de température prédéterminée, la régulation et/ou l'ajustement étant notamment réalisée par l'unité de commande.

Le procédé comporte l'étape de réguler et/ou ajuster la puissance de chauffage délivrée par le deuxième moyen de chauffage suivant une première consigne de température prédéterminée, la régulation et/ou l'ajustement étant notamment réalisée par l'unité de commande.

L'unité de commande comprend des moyens de comparaison de la température mesurée par le capteur de température avec une troisième consigne de température, l'unité de commande étant configurée pour réduire la puissance de chauffage lorsque la température mesurée est supérieure à la troisième consigne de température et pour augmenter la puissance de chauffage lorsque la température mesurée est inférieure à la troisième consigne de température.

L'invention va maintenant être mieux comprise grâce à la description détaillée suivante faite à titre illustratif et non limitatif en référence aux figures annexées décrites ci-après.
[Fig.1] représente schématiquement un dispositif de distribution selon un mode de réalisation de l'invention.
[Fig.2] représente schématiquement un dispositif de distribution selon un autre mode de réalisation de l'invention.
[Fig.3] représente schématiquement un dispositif de distribution selon un autre mode de réalisation de l'invention.
[Fig.4] représente des exemples de distribution de température dans un dispositif de distribution selon un mode de réalisation de l'invention.
[Fig.5] représente schématiquement un dispositif de distribution selon un autre mode de réalisation de l'invention.
[Fig.6] représente schématiquement un dispositif de distribution selon un autre mode de réalisation de l'invention.
[Fig.7]] représente schématiquement un ensemble de distribution selon un mode de réalisation de l'invention.
[Fig.8] représente un exemple d'évolution dans le temps du débit et de la pression d'un précurseur distribué pur par un dispositif selon un mode de réalisation de l'invention.

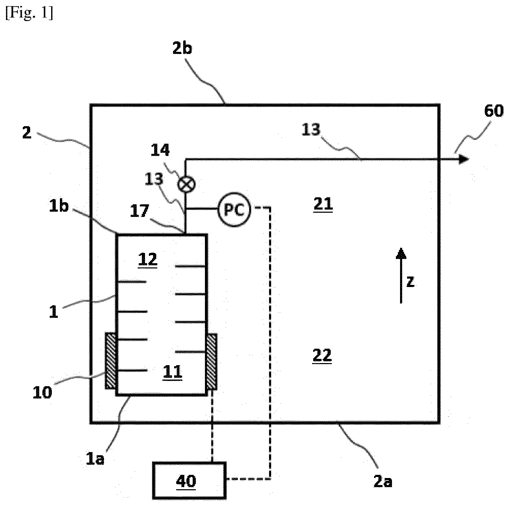

Il est montré sur [Fig.1] un dispositif selon un mode de réalisation de l'invention dans lequel la phase gazeuse du précurseur est distribuée pure.

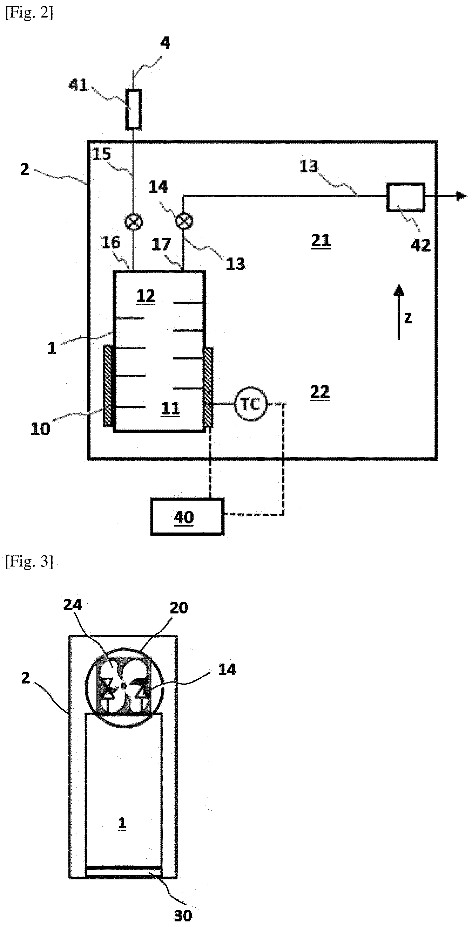

Selon une autre possibilité illustrée sur [Fig.2], un dispositif selon l'invention peut aussi être configuré pour distribuer la phase gazeuse du précurseur diluée dans un gaz porteur.

Par « précurseur », on entend un élément ou composé chimique apte et adapté à amorcer une réaction chimique pour être transformé. En particulier, dans le cas d'un précurseur destiné à réaliser dépôt chimique en phase vapeur, celui-ci est configuré pour réagir et/ou se décomposent à la surface d'un substrat pour y générer le dépôt désiré.

Le précurseur solide peut comprendre tout composé chimique inorganique ou organique à base d'au moins l'un parmi : aluminium, baryum, bismuth, chrome, cobalt, cuivre, or, hafnium, indium, iridium, le fer, lanthane, plomb, magnésium, molybdène, nickel, niobium, platine, ruthénium, argent, strontium, tantale, titane, tungstène, yttrium, zirconium. Par exemple, des précurseurs tels que MoCl₅, MoO₂Cl₂, Mo(CO)₆, W(CO)₆, WCl₆, WCl₅, HfCl₄ peuvent être distribués.

Par « gaz porteur » on entend un gaz apte et adapté à transporter la phase gazeuse du précurseur solide jusqu'à son point d'utilisation, de préférence un gaz formé d'un ou plusieurs corps purs inertes tels l'hydrogène (H2), l'azote (N2), l'argon (Ar) ou l'hélium (He).

Le dispositif selon l'invention vise à distribuer des vapeurs d'un précurseur jusqu'à un point d'utilisation 60, lequel est apte et destiné à être raccordé à une installation de traitement utilisant ledit précurseur. Notons que les termes « installation de traitement » peuvent s'entendre aussi bien d'une entité de traitement unique que de plusieurs entités alimentées en parallèle par la phase gazeuse du précurseur solide, notamment plusieurs entités agencées en aval d'un boîtier de dérivation.

Comme on le voit sur [Fig.1], le dispositif de distribution comprend un récipient 1 contenant une phase solide 11 du précurseur. Le récipient 1 présente un fond 1a, un sommet 1b et une paroi périphérique qui s'étend du fond au sommet. La paroi périphérique peut être de forme générale cylindrique. Le précurseur à l'état solide peut se présenter sous forme de granulés ou de poudre. La pression de vapeur saturante d'un précurseur solide à température ambiante est généralement faible, la quantité de phase gazeuse 12 du précurseur solide contenue dans le récipient 1 et qui peut en être soutirée est donc faible.

Afin d'accroître le débit de phase vapeur distribuée depuis le récipient 1, on agence un premier moyen de chauffage 10 au niveau du récipient 1 de façon à chauffer au moins une partie du récipient 1 et/ou de la phase solide 11. Cela permet de chauffer au moins une partie du précurseur solide dans le récipient 1 et d'accroître la pression de vapeur saturante du précurseur. On augmente ainsi la quantité de précurseur pouvant être sublimée dans le récipient 1 et donc la quantité de phase gazeuse 12 qui peut être distribuée à partir du récipient 1.

Lorsque l'on soutire la phase gazeuse 12 du récipient 1, une partie de la phase solide 11 doit être sublimée de manière à régénérer la phase gazeuse 12 à mesure qu'elle est utilisée afin de maintenir l'équilibre dans le récipient 1. Le chauffage du récipient 1 permet de compenser les pertes de charges dues au retrait de la phase gazeuse 12 du récipient 1 ainsi que d'apporter l'énergie nécessaire pour compenser la perte de température du précurseur solide pour se sublimer.

De préférence, les premiers moyens de chauffage 10 sont externes aux récipients. Il est aussi envisageable que les premiers moyens de chauffage 10 soient internes au récipient.

Selon un mode de réalisation, le premier moyen de chauffage 10 est disposé autour de tout ou partie du récipient 1 et s'étend sur tout ou partie de la hauteur du récipient 1, de préférence au moins au niveau de la partie inférieure du récipient. Cela permet de chauffer en premier lieu la phase solide qui se situe aussi préférentiellement dans la partie inférieure. Notons que la partie inférieure s'entend de préférence d'une partie s'étendant depuis le fond 1a sur une hauteur représentant jusqu'à 50%, en particulier jusqu'à 30%, en particulier encore jusqu'à 20% de la hauteur totale du récipient 1.

Notons que le premier moyen de chauffage peut être configuré pour chauffer au moins une partie de la surface extérieure du récipient 1 et/ou au moins une partie d'éventuels composants internes du récipient 1, notamment des composants internes pouvant servir de supports à la phase solide 11. Le transfert de chaleur à la phase solide 11 a lieu de préférence par conduction thermique entre la surface chauffée et la phase solide 11.

Le premier moyen de chauffage 10 peut se présenter sous la forme d'au moins un cordon chauffant ou d'au moins une ceinture chauffante ou éventuellement d'une coquille à circulation de fluide caloporteur. Selon le cas, le premier moyen de chauffage 10 peut être du type inductif ou résistif. Par exemple, on peut chauffer le corps du récipient 1 à l'aide d'au moins un élément conducteur résistif dans lequel le passage d'un courant électrique produit de la chaleur. Selon une autre possibilité avantageuse, le premier moyen de chauffage 10 comprend des moyens d'induction magnétique capables de créer un champ magnétique dans au moins une partie de l'enveloppe du récipient 1 et de chauffer le matériau du récipient 1 grâce au courant électrique induit.

Des moyens de distribution 13, 14 sont reliés fluidiquement au récipient 1 de façon à distribuer la phase gazeuse 12 depuis le récipient 1 en direction du point d'utilisation 60. Les moyens de distribution peuvent comprendre au moins une portion d'une conduite de distribution 13 dont une extrémité est reliée à une sortie 17 du récipient 1 et une autre extrémité est reliée au point d'utilisation 60. Les moyens de distribution peuvent comprendre au moins une vanne 14 agencée sur le trajet de la phase gazeuse 12 en aval de la sortie 17. De préférence ladite vanne 14 est montée sur la conduite 13.

Selon l'invention, le dispositif comprend en outre une enceinte 2 ayant un volume interne dans lequel sont agencés le récipient 1 et les moyens de distribution 13, 14. Comme on le voit sur [Fig.3], ledit dispositif comprend en outre un deuxième moyen de chauffage 20 configuré pour chauffer au moins une partie du volume interne de l'enceinte 2. En particulier, l'enceinte 2 et le deuxième moyen de chauffage 20 font partie d'un appareil de type étuve ou four. Avantageusement, le transfert de la chaleur a lieu par convection thermique de l'atmosphère chauffée du volume interne vers le récipient 1 et les moyens de distribution 13, 14. En particulier, le transfert de chaleur a lieu par convection forcée.

Le deuxième moyen de chauffage 20 chauffe ainsi à la fois le récipient 1 et les moyens de distribution 13, 14 situés dans le même volume interne. L'utilisation d'une enceinte 2 chauffée permet d'assurer un contrôle plus efficace de la température du précurseur sublimé, simultanément dans le récipient 1 et en aval du récipient 1. La phase gazeuse du précurseur peut être maintenue à une température supérieure ou égale à la température de sublimation tout au long de son trajet depuis le récipient 1. La présence de points plus froids sur le trajet du fluide en aval du récipient peut ainsi être évitée, ce qui évite le risque d'une cristallisation du précurseur. Même le sommet du récipient 1, qui pourrait ne pas être chauffé suffisamment par le premier moyen de chauffage 10, peut être chauffé dans l'enceinte 2. L'agencement des composants principaux du dispositif de distribution dans un même volume permet une régulation plus efficace et plus simple de la température que dans le cas où les composants seraient chauffés par des systèmes chauffants indépendants.

En outre, le deuxième moyen de chauffage 20 chauffe le récipient 1 et contribue à l'augmentation de la pression de vapeur du précurseur solide. Le premier moyen de chauffage 10 et le deuxième moyen de chauffage 20 agissent donc en synergie pour apporter la chaleur nécessaire pour que la pression souhaitée soit atteinte et pour que le débit de précurseur désiré soit assuré.

[Fig.1] montre une enceinte 2 ayant une paroi inférieure 2a et une paroi supérieure 2b avec une direction axiale z qui est sensiblement verticale et orientée dans un sens ascendant, de la paroi inférieure 2a à la paroi supérieure 2b. Avantageusement, le deuxième moyen de chauffage 20 est configuré de sorte que la température du récipient 1 et des moyens de distribution 13, 14 situés dans le volume interne de l'enceinte 2 augmente suivant la direction axiale z. Dit autrement, le deuxième moyen de chauffage 20 est configuré pour générer au sein du récipient 1 et des moyens de distribution 13, 14 un profil de température ayant des températures qui augmentent suivant la direction axiale z.

Les moyens de distribution 13, 14 sont agencés au-dessus du récipient 1 en suivant la direction axiale z. Les moyens de distribution 13, 14 sont ainsi situés dans une région de l'enceinte où les températures sont plus élevées qu'au niveau du récipient 1. La phase gazeuse circulant à travers les moyens de distribution 13, 14 est ainsi chauffée à une température supérieure à la température à laquelle le précurseur est chauffé dans le récipient 1. Cela permet d'avoir en aval du lieu de sublimation une température plus élevée et ainsi d'éviter une condensation de la phase gazeuse pendant son transport jusqu'au point d'utilisation. Dans une enceinte chauffée, en particulier dans un appareil du type four ou étuve, on tire également profit du fait que les températures ont naturellement tendance à augmenter dans un sens ascendant, l'air qui y est contenu étant d'autant moins dense que sa température augmente.

Le profil de température s'entend d'une distribution spatiale de températures en fonction d'un niveau donné suivant la direction axiale z. Les températures du profil sont de préférence déterminées au niveau d'un matériau constitutif du récipient ou des moyens de distribution, en particulier sur la surface externe de ces éléments. Il est aussi envisageable que les températures soient déterminées au niveau d'un fluide contenu dans le récipient ou dans les moyens de distribution. Notons que les températures du profil ne sont pas nécessairement déterminées le long d'un même axe parallèle à la direction axiale z mais qu'elles peuvent être déterminées en différents lieux du volume interne, la variable à considérer étant le niveau du point de mesure dans le volume interne par rapport à la direction axiale z.

De préférence, le profil de température présente une augmentation linéaire de température. Notons qu'un profil de température avec une augmentation par paliers et plusieurs zones à différents niveaux de température est aussi envisageable.

En particulier, le deuxième moyen de chauffage 20 peut être configuré pour générer au sein du récipient 1 et des moyens de distribution 13, 14 un gradient thermique suivant la direction axiale z, en particulier un gradient thermique d'au moins 0.05 °C/cm, de préférence un gradient thermique compris entre 0.05 et 10 °C/cm.

Notons que plus généralement, le deuxième moyen de chauffage peut être configuré pour générer dans le volume interne de l'enceinte 2 une augmentation de la température suivant la direction axiale z.

Selon un mode de réalisation, l'enceinte 2 présente au moins une zone supérieure 21 dans laquelle les moyens de distribution 13, 14 sont agencés et une zone inférieure 22 dans laquelle le récipient 1 est agencé. La zone supérieure 21 est agencée au-dessus de la zone inférieure 22 en suivant la direction axiale z. Le deuxième moyen de chauffage 20 est configuré de manière à ce que la zone supérieure 21 présente une ou des températures supérieures à la ou les températures dans la zone inférieure 22.

De préférence, le récipient 1 comprend un fond 1a et un sommet 1b, le sommet 1b étant agencé à un niveau supérieur à celui du fond 1a en suivant la direction axiale z Le deuxième moyen de chauffage 20 est configuré de sorte qu'une première température déterminée au niveau des moyens de distribution 13, 14 est supérieure à une deuxième température déterminée au niveau du sommet 1b.

De préférence, la délimitation entre la zone inférieure 22 et la zone supérieure 21 se situe au niveau ou au voisinage du sommet 1b du récipient 1.

Avantageusement, le deuxième moyen de chauffage 20 est configuré de sorte que le profil de température présente une deuxième température au niveau du sommet 1b et une troisième température au niveau du fond 1a. La deuxième température est supérieure à la troisième température. Ce contrôle de la distribution de la température du récipient 1 permet d'éviter une recristallisation des vapeurs du précurseur dans la partie supérieure du récipient, là où elles seraient difficiles à resublimer et pourraient engendrer des bouchages. Cette distribution favorise la recristallisation des vapeurs dans la partie inférieure du récipient.

En particulier, le deuxième moyen de chauffage 20 peut être configuré de sorte que le récipient 1 et les moyens de distribution 13, 14 présentent plusieurs niveaux de températures le long de la direction axiale z choisis parmi :
- une première température mesurée au niveau des moyens de distribution 13, 14, de préférence à une hauteur comprise entre 25 et 100 cm au-dessus du sommet du récipient 1
- une deuxième température mesurée au niveau du sommet du récipient 1,
- une troisième température mesurée au niveau du fond du récipient 1,
- une quatrième température mesurée à un niveau intermédiaire entre le fond et le sommet du récipient 1, de préférence à une distance comprise entre 20 et 40 cm du fond du réservoir 1

De préférence, l'écart entre la première température et la deuxième température est compris entre 1 et 35 °C, de préférence entre 1 et 10 °C. De préférence l'écart entre la première température et la troisième température est compris entre 3 et 30 °C. De préférence l'écart entre la première température et la quatrième température est compris entre 2 et 70 °C, de préférence entre 2 et 20 °C. De préférence l'écart entre la première température et la quatrième température est compris entre 2 et 70 °C, de préférence entre 2 et 20 °C.

La section de passage de la canalisation en sortie du récipient étant plus faible que la section du récipient, il est avantageux de maintenir les moyens de distribution 13 et 14 à une température supérieure à la température du sommet du récipient 1, ceci afin d'éviter la cristallisation du précurseur dans les canalisations 13 ou dans les vannes 14 en aval du récipient 1.

Selon des possibilités de réalisation, le récipient 1 présente une première hauteur comprise entre 20 et 100 cm et/ou l'enceinte 2 présente une deuxième hauteur comprise entre 30 et 150 cm. La première hauteur est mesurée à l'intérieur du récipient 1, entre le sommet et le fond et parallèlement à la direction axiale z. La deuxième hauteur est mesurée à l'intérieur de l'enceinte, entre la paroi inférieure et la paroi supérieure et parallèlement à la direction axiale z.

De préférence, le précurseur solide est agencé dans la partie inférieure du récipient 1. Selon un mode de réalisation, le précurseur solide est agencé dans le récipient 1 à une hauteur comprise entre 0 et 90 cm, ladite hauteur étant mesurée à partir du fond du récipient 1.

Comme on le voit sur [Fig.3], le deuxième moyen de chauffage 20 peut comprendre au moins une résistance électrique, agencée à un niveau supérieur de l'enceinte, de préférence dans la zone où sont situés les moyens de distribution 13, 14. De préférence, le deuxième moyen 20 est disposé dans ou sur une paroi latérale de l'enceinte 2.

De préférence, le deuxième moyen de chauffage 20 est associé à un moyen de circulation d'air 24 configuré pour faire circuler de l'air depuis le deuxième moyen de chauffage 20 en direction du volume interne de l'enceinte 2. En particulier, les moyens de circulation 24 peuvent comprendre au moins un ventilateur. De préférence le moyen de circulation d'air 24 est configuré pour récupérer de l'air froid de l'intérieur de l'enceinte, de préférence d'une région centrale de l'enceinte, pour qu'il soit chauffé par le deuxième moyen de chauffage 20 et pour rejeter l'air chauffé dans le volume interne, de préférence par les côtés. L'air peut circuler au sein de l'étuve en circuit fermé, notamment l'air mis en circulation est chauffé, circule dans l'enceinte puis est aspiré par les moyens de circulation pour être à nouveau dirigé vers le deuxième moyen de chauffage 20.

Optionnellement, l'enceinte peut aussi comprendre des moyens d'apport d'air extérieur à l'enceinte tels au moins une ouverture agencée à proximité des moyens de circulation 24, et des moyens d'évacuation d'air reliés à l'extérieur de l'enceinte. Ces moyens d'évacuation de l'air chaud de l'enceinte peuvent être utilisés pour refroidir l'enceinte plus rapidement si nécessaire ou pour extraire l'air de l'enceinte en cas de problème, tel une fuite).

Avantageusement, le deuxième moyen de chauffage 20 est relié à un organe de commande permettant d'ajuster la puissance de chauffage de manière à ajuster la température de chauffage du récipient 1. On peut ainsi ajuster et/ou modifier le profil de température du récipient 1 et des moyens de distribution 13, 14. De préférence, l'organe de commande est configuré pour réguler et/ou ajuster la puissance de chauffage délivrée par le deuxième moyen de chauffage 20 suivant une première consigne de température d'une valeur prédéterminée. Une fois la valeur prédéterminée choisie, la régulation se fait à consigne de température constante. Le maintien en température peut se faire par comparaison d'une température mesurée au niveau du deuxième moyen 20 avec la première consigne et régulation en boucle fermée.

Avantageusement, le dispositif selon l'invention comprend en outre un troisième moyen de chauffage 30 agencé dans l'enceinte 2. De préférence, le troisième moyen de chauffage 30 est agencé, suivant la direction z, à un niveau inférieur au niveau du deuxième moyen de chauffage dans l'enceinte 2.

De préférence, le troisième moyen de chauffage 30 est agencé dans la zone inférieure 22 de l'enceinte 2, de préférence au niveau de la partie inférieure du récipient 1, et avantageusement au niveau du fond du récipient 1 ou sous le récipient 1.

Selon une possibilité, le troisième moyen de chauffage 30 comprend un plateau chauffant agencé sous le récipient 1, en particulier un plateau formé d'un matériau conducteur thermique tel de l'aluminium muni d'au moins une résistance électrique qui chauffe le plateau. Le troisième moyen de chauffage 30 est configuré pour chauffer au moins une partie du récipient 1, de préférence par conduction thermique. L'apport de chaleur a lieu de préférence au niveau du fond du récipient 1. La chaleur se diffuse par conduction dans les parois du récipient 1, du fond vers le sommet.

Avantageusement, le troisième moyen de chauffage 30 est relié à un organe de commande permettant d'ajuster la puissance de chauffage de manière à ajuster la température de chauffage du récipient 1. On ajuste ainsi le différentiel de température présenté par le récipient 1 suivant la direction axiale z. De préférence, l'organe de commande est configuré pour réguler et/ou ajuster la puissance de chauffage délivrée par le troisième moyen de chauffage 30 suivant une deuxième consigne de température d'une valeur prédéterminée. Une fois la valeur prédéterminée choisie, la régulation se fait à consigne de température constante. Le maintien en température peut se faire par comparaison d'une température mesurée au niveau du troisième moyen 30 avec la consigne et régulation en boucle fermée.

Le troisième moyen de chauffage 30 permet d'apporter de la chaleur additionnelle en complément du deuxième moyen de chauffage 20, ceci afin de sublimer plus facilement le précurseur solide. Cela fournit un degré de liberté supplémentaire pour les ajustements de la différence de température entre le sommet et le fond du récipient et de la différence de température entre le fond du récipient 1 et les moyens de distribution 13, 14. On peut ainsi adapter le profil de températures aux conditions de sublimation dans le dispositif, notamment nature du précurseur, pression et/ou débit de distribution...

En particulier, l'unité de commande permet d'ajuster la température à laquelle le fond du récipient 1 est chauffé. Ainsi, en augmentant la deuxième consigne, cela augmente la puissance du troisième moyen de chauffage, la température du fond du récipient 1 peut être augmentée et les différences de température entre le sommet et le fond du récipient et entre le fond du récipient 1 et les moyens de distribution 13, 14 peuvent être réduites. A l'inverse, une diminution de la deuxième consigne de température induit une diminution de la puissance du troisième moyen de chauffage et peut permettre d'augmenter les différences de température. Notons que le dispositif peut être configuré pour permettre un ajustement relatif des puissances délivrées par le troisième moyen et le deuxième moyen de chauffage.

Selon un mode de réalisation particulier, le deuxième moyen de chauffage est configuré de sorte que l'écart entre la première température et la deuxième température est compris entre 1 et 35 °C lorsque seuls le deuxième moyen de chauffage et le premier moyen de chauffage sont en fonctionnement. Le deuxième moyen de chauffage et le troisième moyen de chauffage peuvent être configurés de sorte que l'écart entre la première température et la deuxième température est compris entre 1 et 10 °C lorsque le deuxième moyen de chauffage, le premier moyen de chauffage et le troisième moyen sont en fonctionnement.

De façon alternative ou complémentaire, le deuxième moyen de chauffage peut être configuré de sorte que l'écart entre la première température et la troisième température est compris entre 2 et 70 °C lorsque seuls le deuxième moyen de chauffage et le premier moyen de chauffage sont en fonctionnement. Le deuxième moyen de chauffage et le troisième moyen de chauffage peuvent être configurés de sorte que l'écart entre la première température et la troisième température est compris entre 2 et 20 °C lorsque le deuxième moyen de chauffage, le premier moyen de chauffage et le troisième moyen sont en fonctionnement.

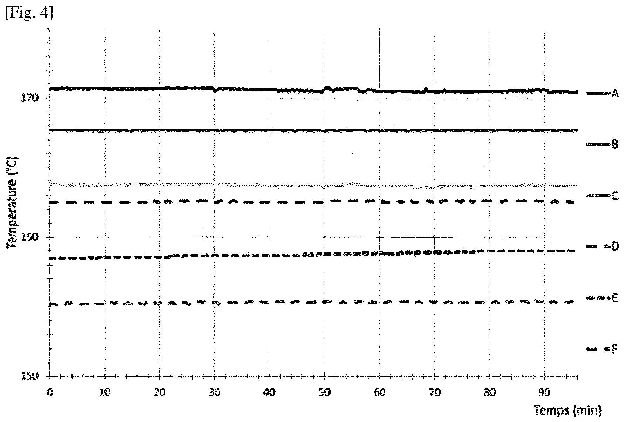

[Fig.4] illustre un exemple de distribution de température dans une enceinte d'un dispositif selon un mode de réalisation de l'invention. Le récipient 1 a une première hauteur de 49 cm. L'enceinte 2 a une deuxième hauteur de 135 cm. Le deuxième moyen de chauffage 20 chauffe la zone supérieure 21 de l'enceinte et, dans une moindre mesure, la zone inférieure 22 de l'enceinte. Le troisième moyen de chauffage 30 chauffe le fond du récipient 1. Une partie de la chaleur se répand vers le haut du récipient par conduction thermique. Les courbes donnent l'évolution dans le temps de températures à différents niveaux sur le récipient 1 et sur les moyens de distribution 13 et 14 le long de la direction axiale z.

La courbe A correspond à une mesure de température au niveau d'un moyen de distribution 13 agencée à une distance de l'ordre de 60 cm au-dessus du sommet du récipient 1. La courbe B correspond à une mesure de température au niveau d'une vanne 14 agencée à une distance de l'ordre de 13 cm au-dessus du sommet du récipient 1. La courbe C correspond à une mesure de température au niveau du sommet du récipient 1. La courbe D correspond à une mesure de température au milieu de la hauteur du récipient 1. La courbe E correspond à une mesure de température à une distance de 5 cm au-dessus du fond du récipient 1. La courbe F correspond à une mesure de température mesurée au niveau du fond du récipient 1.

Avantageusement, un transfert thermique a lieu par convection entre l'air chaud contenu dans l'enceinte 2 et le récipient 1 et les moyens de distribution 13 et 14 lors de l'utilisation du deuxième moyen de chauffage 20. Cependant, la convection naturelle peut ne pas suffire à elle seule d'apporter l'énergie nécessaire pour assurer les débits de phase gazeuse souhaités à l'échelle industrielle, notamment pour des applications de dépôt chimique en phase vapeur où les taux de dépôt souhaités sont de plus en plus élevés.

Les premier, deuxième et/ou troisièmes moyens de chauffages peuvent chauffer le récipient 1 de façon à ce que la pression de vapeur du précurseur augmente. Le deuxième moyen sert notamment à générer le profil de température. Le troisième moyen peut servir à ajuster ce profil. Les premier, deuxième et/ou troisièmes moyens de chauffage agissent comme des moyens complémentaires pour adapter le mieux possible le profil de température aux conditions d'utilisation.

Le moyen de chauffage qui prédomine dans l'apport de chaleur nécessaire pour que la pression souhaitée soit atteinte et pour que le débit de précurseur désiré soit assuré peut dépendre des conditions d'utilisation du dispositif. En particulier, cela peut dépendre du niveau de remplissage du récipient 1 et de la surface de contact du précurseur avec le volume environnant. Lorsque le récipient 1 est plein, le premier moyen de chauffage et le deuxième moyen de chauffage ont le plus d'influence. Lorsque le récipient 1 est relativement peu rempli, voire presque vide, le troisième moyen de chauffage a le plus d'influence dans le chauffage du précurseur.

Le précurseur solide 11 chauffé se sublime en utilisant l'énergie disponible fournie par les différents moyens de chauffage au récipient 1. Le débit de distribution du précurseur pur est conditionné par sa vitesse de sublimation. Plus le débit de soutirage demandé est élevé, plus le besoin d'énergie est important et plus le récipient doit être chauffé. Il en est de même lorsqu'on veut augmenter la pression du fluide distribué par le récipient du fait d'une pression plus élevée demandée au point d'utilisation. Dans les deux cas, il est nécessaire d'augmenter la chaleur transférée par les premiers moyens de chauffage. Par ailleurs, si le débit de consommation des vapeurs de précurseur diminue au point d'utilisation, il est aussi nécessaire de réduire le chauffage du récipient 1 afin de réduire la quantité de phase gazeuse 12 sublimée.

Selon un mode de réalisation avantageux, comme par exemple schématisé sur [Fig.1] , les premiers moyens de chauffage 10 sont configurés pour délivrer une puissance de chauffage variable. Typiquement, les moyens de chauffage 10 sont reliés à un organe d'alimentation électrique et la puissance de chauffe varie en fonction de l'intensité du courant d'alimentation appliqué aux premiers moyens de chauffage 10. Le dispositif comprend en outre au moins un capteur de pression PC configuré pour mesurer la pression à l'intérieur du récipient 1. Le capteur de pression PC est relié fluidiquement au volume intérieur du récipient 1. Le capteur de pression PC peut être monté au niveau des moyens de distribution 13, 14, de préférence en aval de la sortie d'une vanne 14 contrôlant la distribution de la phase gazeuse 12, ladite vanne étant agencée en aval de la sortie 17 ou bien entre la sortie 17 du récipient 1 et la vanne 14, ou bien directement sur le récipient 1. Le capteur de pression peut aussi se situer à l'extérieur de l'enceinte et être relié fluidiquement au récipient 1. Une unité de commande 40 est reliée au capteur de pression PC et aux premiers moyens de chauffage 10. L'unité de commande 40 est configurée pour faire varier la puissance de chauffage délivrée par les premiers moyens de chauffage 10 en fonction de la pression mesurée par le capteur de pression PC.

Notons qu'en parallèle, le deuxième moyen de chauffage continue avantageusement à chauffer le volume interne de l'enceinte 2 et le récipient 1.

La puissance de chauffage est ainsi adaptée pour adapter la température à laquelle le précurseur est chauffé dans le récipient 1 afin de stabiliser la pression dans le récipient 1. En cas de variation, l'unité de commande adapte les conditions de chauffage par les premiers moyens 10 de façon à ajuster la pression dans le récipient. On assure ainsi une distribution continue avec un débit de phase gazeuse stable. Ce mode de régulation est plus efficace et plus sûr qu'une régulation indépendante des premiers moyens de chauffage puisqu'une variation de pression traduit directement et immédiatement l'état du système physique dans le récipient 1.

Ce mode de réalisation est adapté au cas où le précurseur est distribué pur, puisque la pression dans le récipient 1 correspond à la pression de phase gazeuse 12 et reflète directement la quantité de précurseur qui peut être sublimé.

De préférence, l'unité de commande 40 est configurée pour comparer la pression mesurée à l'intérieur du récipient 1 avec une pression de consigne. La puissance de chauffage est augmentée lorsque la pression mesurée à l'intérieur du récipient 1 est inférieure à la pression de consigne. La puissance de chauffage est réduite lorsque la pression mesurée à l'intérieur du récipient 1 est supérieure ou égale à la pression de consigne. Notons que la réduction de la puissance de chauffe s'entend d'un chauffage à une puissance moins élevée ou d'un arrêt du chauffage, en fonction de la différence de pression calculée par l'unité de commande 40 entre la consigne de pression et la pression du système mesurée.

La pression de consigne peut être prédéfinie en fonction notamment des conditions opératoires de l'installation, des composants de l'installation, de la pression et du débit demandés au point d'utilisation et/ou de la nature du précurseur, chaque molécule de précurseur ayant une courbe spécifique de variation de sa pression de vapeur saturante en fonction de la température. De préférence, la pression de consigne est définie et les premiers moyens de chauffage 10 sont configurés pour que, lorsqu'ils fonctionnent à une puissance dite nominale, le précurseur est chauffé à une température à laquelle sa pression de vapeur saturante est égale à la pression de consigne. Plus la différence entre la pression de consigne et la pression mesurée dans le récipient 1 est importante, plus la puissance des premiers moyens de chauffage est augmentée par rapport à la puissance nominale.

Optionnellement, l'unité de commande 40 peut en outre être configurée pour comparer la pression mesurée à l'intérieur du récipient 1 avec un seuil haut de pression. Notons que le dispositif peut comprendre une ligne de mise à l'air avec un évent associé à une soupape ou un réseau de vide 61 relié fluidiquement au récipient 1, et au moins une vanne contrôlant le passage du fluide vers le réseau de vide. Si la pression mesurée par le capteur de pression PC est supérieure au seuil haut de pression, l'unité de commande 40 commande l'ouverture de cette soupape ou de cette vanne, ce qui permet de réduire la pression dans le récipient 1 plus rapidement et de fournir une sécurité supplémentaire. La [Fig.4] représente un exemple de réalisation dans lequel la pression est relâchée grâce à une vanne trois voies reliée à une ligne de vide 61.

Eventuellement, le dispositif peut comprendre une conduite de purge 63 reliée fluidiquement au récipient 1 et aux moyens de distribution 13, 14 de façon à y acheminer un gaz de purge. Cela permet, au cours des phases de démarrage ou d'entretien de purger les canalisations du dispositif et le récipient 1.

La régulation du chauffage du récipient 1 en fonction de la pression permet également d'adapter la température à laquelle le récipient 1 est chauffé en fonction du débit de phase gazeuse demandé au point d'utilisation 60. Typiquement, si le débit demandé au point de consommation augmente, il s'ensuit une diminution de la pression mesurée par le capteur PC car il n'y a pas assez de précurseur sublimé. En réponse, l'unité de commande 40 ordonne une augmentation de la puissance de chauffage afin d'augmenter la pression de vapeur saturante et de sublimer plus de précurseur. Si le débit et/ou la pression demandée au point de consommation diminue, il s'ensuit une augmentation de la pression mesurée par le capteur PC du fait de l'excès de précurseur sublimé. En réponse, l'unité de commande 40 ordonne une diminution de la puissance de chauffage afin de sublimer moins de précurseur et/ou l'ouverture de la soupape ou de la vanne allant au réseau de vide 61 si le seuil haut de pression est dépassé.

Avantageusement, le dispositif selon l'invention met en œuvre une première boucle d'asservissement de la puissance des premiers moyens de chauffage 10 sur la pression mesurée par le capteur PC. Par « boucle d'asservissement » on entend généralement un système de contrôle d'un procédé dans lequel une grandeur réglante agit sur une grandeur réglée, i. e. une grandeur à asservir, pour l'amener le plus rapidement possible à une valeur de consigne et l'y maintenir. Le principe de base d'un asservissement est de mesurer, en permanence, l'écart entre la valeur réelle de la grandeur à asservir et la valeur de consigne que l'on désire atteindre, et de calculer la commande appropriée à appliquer à un ou plusieurs actionneurs de façon à réduire cet écart le plus rapidement possible. On parle également de système commandé en boucle fermée.

Dans la boucle d'asservissement, la grandeur réglante est la pression mesurée par le capteur PC, la grandeur réglée est la puissance de chauffe du récipient 1, et donc indirectement la température de chauffe de la phase solide 11, via le réglage de la puissance des premiers moyens de chauffage 10.

Outre le capteur PC, la boucle d'asservissement comprend un comparateur agencé au sein de l'unité de commande 40 et configuré pour élaborer au moins un signal d'erreur à partir de la comparaison entre pression mesurée et consigne de pression. La boucle comprend un correcteur configuré pour élaborer le signal de commande à partir du signal d'erreur. Le correcteur envoie le signal de commande à l'unité 40 qui commande l'ajustement de la puissance de chauffe. De préférence, le correcteur est du type proportionnel, intégral et dérivé (PID), ce qui permet d'améliorer les performances d'un asservissement grâce à trois actions combinées : une action proportionnelle, une action intégrale, une action dérivée. Les termes proportionnel, intégral, et dérivé peuvent être déterminés par calcul et/ou expérimentalement. Le terme dérivé du D peut éventuellement être nul.

Avantageusement, l'unité de commande 40 comprend un automate programmable, également appelé système « PLC » pour « Programmable Logic Controller » en anglais, c'est-à-dire un système de contrôle d'un procédé industriel comprenant une interface homme-machine pour la supervision et un réseau de communication numérique. Le système PLC peut comprendre plusieurs contrôleurs modulaires qui commandent les sous-systèmes ou équipements de contrôle du dispositif. Ces équipements sont configurés chacun pour assurer au moins une opération parmi : l'acquisition des données d'au moins un capteur de mesure, le contrôle d'au moins un actionneur relié à au moins un organe contrôleur de débit ou de pression, la régulation et l'asservissement de paramètres, la transmission de données entre les différents équipements du système.

L'unité de commande 40 peut ainsi comprendre au moins l'un parmi : un micro-contrôleur, un microprocesseur, un ordinateur. L'unité de commande 40 peut être reliée aux différents équipements de contrôle du dispositif, notamment aux organes régulateurs de débit, de pressions, aux capteurs, aux organes de commande des moyens de chauffage, et communiquer avec lesdits équipements par des liaisons électriques, Ethernet, Modbus... D'autres modes de liaisons et/ou transmission d'informations, sont envisageables pour tout ou partie des équipements du dispositif, par exemple par liaisons radiofréquence, WIFI, Bluetooth...

Notons que les termes « unité de commande », couvre une même unité commandant les différents moyens de chauffage ou bien plusieurs organes de commande qui peuvent commander indépendamment tout ou partie des moyens de chauffage.

Selon une possibilité de mise en œuvre, l'unité de commande 40 comprend une interface homme-machine comprenant une interface de saisie, par exemple un écran tactile, permettant la saisie par un utilisateur d'instructions à destination de l'unité de commande 40 et/ou de données relatives notamment à la nature du précurseur, au débit et/ou à la pression de distribution souhaitée, à l'installation de traitement...

[Fig.2] illustre un mode de réalisation dans lequel le dispositif est destiné à distribuer une phase gazeuse 12 diluée dans un gaz porteur 4. Notons que tout ou partie des caractéristiques décrites précédemment sont transposables au cas de la distribution de la phase gazeuse diluée, notamment les caractéristiques relatives à l'unité de commande, à la boucle de régulation, à l'enceinte, aux deuxièmes moyens de chauffage...

Une source de gaz porteur 4 est reliée par une conduite d'alimentation 15 à une entrée 16 du récipient 1. La source de gaz porteur 4 peut être un contenant dans lequel le gaz porteur peut être stocké à l'état gazeux, à l'état liquide, i. e. de gaz liquéfié, ou diphasique liquide/gaz, tel une bouteille de gaz, un ensemble de bouteilles raccordées entre elles pour former un cadre de bouteilles ou un réservoir de plus grande contenance, tel un réservoir de stockage cryogénique.

Le dispositif comprend des moyens de circulation du gaz porteur 41, 42 configurés pour faire circuler le gaz porteur 4 entre l'entrée 16 et la sortie 17 du récipient 1 de sorte que le gaz porteur 4 se charge en phase gazeuse 12 lorsqu'il circule dans le récipient 1. Un mélange de précurseur et de gaz porteur est ainsi distribué vers le point d'utilisation.

Le dispositif selon l'invention peut notamment être utilisé pour produire des mélanges de vapeurs de précurseur et de gaz porteur ayant des teneurs en précurseur comprises entre 1 ppmm et 10 %, de préférence entre 50 ppmm et 5 % (ppm et % massiques), le reste étant le gaz porteur. Par exemple, des mélanges ayant les compositions suivantes peuvent être distribués : 1700 ppm de WCl₅ dans N₂, 3,5% de WCl₆ dans N₂.

Afin de s'adapter à la pression et/ou au débit demandé au point d'utilisation 60, les moyens de circulation du gaz porteur 41, 42 sont configurés pour réguler le débit de gaz porteur 4 envoyé dans le récipient 1 et/ou pour réguler la pression dans le récipient 1. Selon le cas, les moyens de circulation du gaz porteur 41, 42 peuvent comprendre au moins l'un parmi : un régulateur de débit amont 41 agencé en amont du récipient 1 de façon à réguler le débit du gaz porteur 4 s'écoulant vers le récipient 1, un régulateur de pression amont 41 agencé en amont du récipient 1 de façon à réguler la pression dans le récipient 1, un régulateur de débit aval 42 agencé en aval du récipient 1 de façon à réguler le débit du mélange gazeux s'écoulant depuis le récipient 1, un régulateur de pression aval 42 agencé en aval du récipient 1 permettant de réguler la pression dans le récipient 1. Le régulateur de pression 42 peut être un contrôleur de débit (utilisé pour contrôler la pression), un déverseur, un régulateur de contre-pression, une vanne papillon...

En particulier, la conduite d'alimentation 15 peut être munie d'un détendeur 41 et/ou la conduite de distribution 13 peut être munie d'un déverseur 42 afin de réguler la pression dans le récipient 1. Le déverseur 42 fonctionne en régulateur de pression amont, c'est-à-dire qu'il est configuré pour réguler la pression du fluide dans le circuit de gaz en amont du déverseur 42. L'utilisation du déverseur 42 permet de maintenir constante la pression en amont, alors que la pression aval peut fluctuer. Selon un mode de réalisation, le déverseur peut comprendre une chambre montée en dérivation, un clapet piloté par une membrane de commande. Cette membrane est équilibrée d'une part par un ressort taré prévu pour fermer et ouvrir un conduit relié au circuit du gaz et d'autre part par la pression à stabiliser en amont. La pression dans le récipient peut par exemple être maintenue constante, en particulier à une valeur comprise entre 67 mbara et 2 bara (bar absolu).

En particulier, le dispositif peut comprendre au moins un détendeur 41 qui fonctionne en réducteur de pression aval. Le détendeur 41 est configuré pour réguler la pression du mélange distribué et assure la stabilité de la pression au point d'utilisation du mélange afin de satisfaire aux exigences de l'installation de traitement en termes de précision et de stabilité des paramètres du mélange. En particulier, le détendeur 41 peut être monté en série sur la conduite 15.

En particulier, la conduite d'alimentation 15 peut être munie d'un régulateur de débit 41 et/ou la conduite de distribution 13 peut être munie d'un régulateur de débit 42 afin de réguler le débit de gaz porteur 4 traversant le récipient 1. Chaque organe régulateur de débit 41, 42 peut être tout moyen configuré pour régler, réguler, ajuster le débit d'écoulement d'un fluide pour l'amener à une valeur de débit la plus proche de la valeur souhaitée. Typiquement, les organes régulateurs de débit 41, 42 comprennent chacun un débitmètre, associé à un organe de détente, tel une vanne, par exemple une vanne à réglage proportionnel. La vanne comprend une partie mobile, typiquement au moins un obturateur, qui est placé dans le débit de fluide et dont le déplacement permet de faire varier la section de passage, et ainsi faire varier le débit pour l'amener à la valeur de consigne.

Comme on effectue une dilution du précurseur 12 dans le gaz porteur 4, la concentration de la phase gazeuse du précurseur dans le gaz porteur est déterminée par le rapport entre le débit de précurseur sublimé et le débit de gaz porteur. La stabilité de la concentration de la phase gazeuse du précurseur dans le gaz porteur est assurée par la saturation du gaz porteur dans le récipient 1 et par la stabilité de la température du récipient 1. La stabilité du débit de mélange distribué au point d'utilisation est ainsi assurée par la stabilité du débit de gaz porteur circulant dans le récipient 1.

L'unité de commande 40 peut ainsi être reliée aux organes régulateurs précédemment décrits de façon à commander leur fonctionnement, en particulier de façon à ajuster les valeurs de consigne qui leur sont appliquées pour les amener à des valeurs déterminées en fonction de conditions de fonctionnement de l'installation.

Comme on le voit sur [Fig.2], le dispositif comprend avantageusement au moins un capteur de température TC configuré pour mesurer la température d'une surface extérieure du récipient 1. Le capteur TC peut être tout capteur configuré pour réaliser des mesures de température par contact, en particulier un capteur de température par résistance, par exemple un capteur à résistance de platine du type PT100, ou bien une sonde de température à thermocouple ou à thermistance.

De préférence, le capteur de température TC est configuré pour mesurer la température d'au moins une portion de la surface extérieure d'une paroi du récipient 1, de préférence la paroi périphérique située entre le fond et le sommet. De préférence, le capteur TC est agencé à une hauteur du récipient au niveau de laquelle s'étend le premier moyen de chauffage 10. Cela fournit une plus grande précision et rapidité de régulation.

L'unité de commande 40 est reliée au capteur de température TC et aux premiers moyens de chauffage 10, l'unité de commande 40 étant configurée pour faire varier la puissance de chauffage délivrée par les premiers moyens de chauffage 10 en fonction de la température mesurée par le capteur de température TC.

Avantageusement, l'unité de commande 40 comprend des moyens de comparaison de la température mesurée par le capteur TC avec une troisième consigne de température d'une valeur prédéterminée. L'unité de commande 40 est configurée pour réduire la puissance de chauffage lorsque la température mesurée est supérieure à la troisième consigne de température et pour augmenter la puissance de chauffage lorsque la température mesurée est inférieure à la troisième consigne de température. Notons que la réduction de la puissance de chauffe s'entend d'un chauffage à une puissance moins élevée ou d'un arrêt du chauffage en fonction de la différence de température calculée par l'unité de commande 40 entre la troisième consigne de température et la température mesurée.

La température à laquelle le récipient 1 est chauffé est stabilisée à sa valeur de consigne. On assure ainsi une distribution continue avec un débit de phase gazeuse stable. Ce mode de réalisation est adapté au cas où le précurseur est distribué dilué puisque dans ce cas, la pression dans le récipient 1 est fonction de la pression du gaz porteur 4 et de la température du précurseur.

La troisième consigne de température peut être définie en fonction notamment des conditions opératoires et des composants de l'installation, de la pression, du débit demandés au point d'utilisation et/ou de la nature du précurseur. De préférence, les premiers moyens de chauffage 10 sont configurés pour que, lorsqu'ils fonctionnent à une puissance dite nominale, la température de surface du récipient mesurée par le capteur TC soit égale à la troisième consigne de température. La troisième consigne est déterminée de façon à ce que la concentration de vapeur de précurseur dans le gaz vecteur satisfasse les spécifications de l'installation de traitement. Si l'installation de traitement a besoin d'une concentration importante de précurseur, la troisième consigne de température va être augmentée afin d'augmenter la pression de vapeur saturante du précurseur. Si l'installation de traitement a besoin d'une concentration moins importante de précurseur, la consigne va être réduite pour diminuer la pression de vapeur saturante du précurseur.

Notons que le dispositif selon l'invention peut comprendre à la fois un capteur de pression PC et un capteur de température TC tels que décrits précédemment. Cela permet avec le même dispositif de pouvoir opérer une régulation de la puissance de chauffage dans un mode de distribution de précurseur pur ou dans un mode de distribution de précurseur dilué. En fonction du mode de fonctionnement, l'unité de commande 40 est configurée pour élaborer des signaux de commande de la puissance de chauffage à partir de mesures provenant de l'un ou l'autre des capteurs.

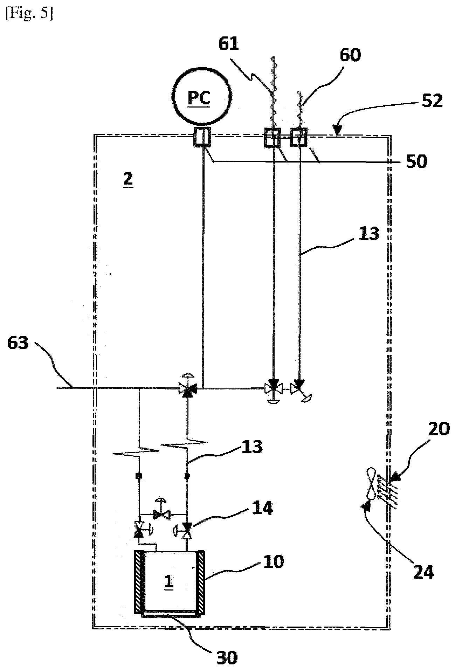

Comme on le voit sur [Fig.5], les moyens de distribution 13, 14 comprennent au moins une conduite de distribution 13 traversant une première paroi 52 de l'enceinte 2. Le dispositif peut comprendre en outre au moins un élément chauffant 50 formant un manchon autour d'au moins une partie de la conduite de distribution 13 et s'étendant de part et d'autre de ladite première paroi 52.

En effet, comme les parois de l'enceinte sont généralement isolées afin de garantir l'étanchéité thermique, les passages de parois peuvent former des points froids sur le trajet de la phase gazeuse 12, ce qui engendre un risque de recristallisation de la phase gazeuse aux passages de parois. Pour remédier à cela, on insère un ou plusieurs éléments chauffants dans les parois de l'enceinte et on chauffe la conduite de distribution au niveau de son passage dans la paroi de manière à éviter la recristallisation du précurseur sublimé et à maintenir une température croissante suivant la direction axiale z.

Selon un mode de réalisation particulier, l'élément chauffant 50 peut comprendre deux demi-coquilles chauffantes formées d'un matériau conducteur thermique. Les demi-coquilles peuvent contenir une ou plusieurs cartouches chauffantes ainsi qu'au moins une sonde de température. Les coquilles sont insérées dans la paroi de l'enceinte et sont chauffées, de préférence à température constante.

Comme dans l'exemple de [Fig.5], il est aussi possible d'agencer un élément chauffant 50 autour de la ligne de vide 61 et/ou autour d'une ligne de mesure de mesure de pression 62.

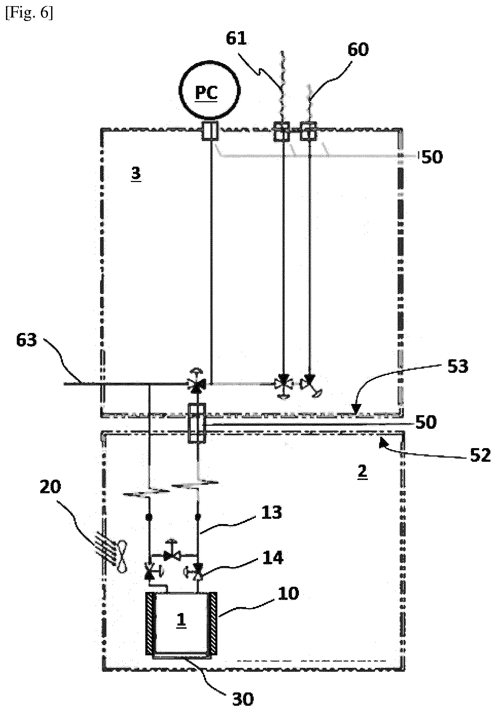

[Fig.6] schématise un mode de réalisation dans lequel le dispositif de distribution comprend en outre au moins une enceinte additionnelle 3 ayant une deuxième paroi 53 agencée en regard de la première paroi 52 de l'enceinte 2. La conduite de distribution 13 acheminant les vapeurs de précurseurs depuis le récipient 1 traverse la deuxième paroi 53 de l'enceinte additionnelle 3 et distribue les vapeurs vers le point d'utilisation 60. Notons que l'enceinte additionnelle 3 n'est pas nécessairement positionnée au-dessus de l'enceinte 2 mais que d'autres agencements sont possibles, selon le lieu du point d'utilisation et l'empreinte au sol disponible.

L'enceinte additionnelle 3 comprend des troisièmes moyens de chauffage configurés pour chauffer au moins une partie du volume interne de l'enceinte additionnelle 3 à des températures supérieures aux températures de l'enceinte 2. On respecte ainsi une augmentation de la température suivant la direction axiale z afin d'éviter la recristallisation du produit dans les lignes de l'enceinte 3. De préférence, un élément chauffant 50 tel que décrit précédemment est agencé autour de la conduite de distribution 13 au niveau de son passage à travers la deuxième paroi 53.

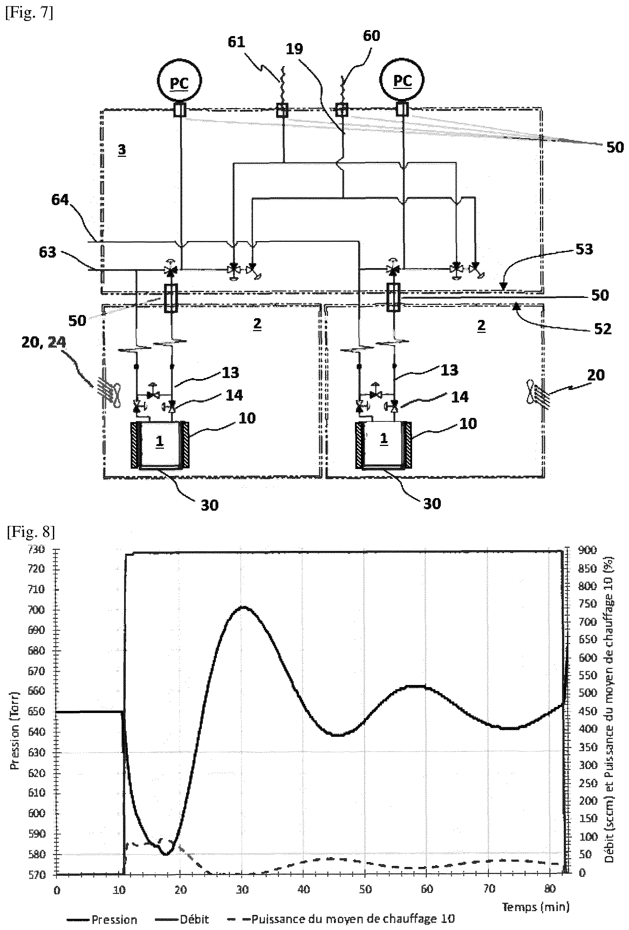

Dans un mode de réalisation illustré sur [Fig.7], un ensemble de distribution est réalisé avec au moins deux dispositifs de distribution selon l'invention agencés en parallèle. Plus précisément, chaque dispositif comprend un récipient 1 et des moyens de distribution 13, 14 respectifs reliés fluidiquement à une canalisation commune 19, elle-même reliée au point de consommation 60. Notons que l'agencement d'une enceinte additionnelle 3 est optionnel.

Avantageusement, l'ensemble comprend des moyens de basculement configurés pour occuper une première position dans laquelle la phase gazeuse 12 est distribuée dans la canalisation commune 19 à partir de l'un des deux récipients. Les moyens de basculement peuvent comprendre les vannes 14 des moyens de distribution 13, 14 respectifs et/ou des vannes additionnelles reliées aux moyens de distribution telles des vannes coudées, comme visibles sur [Fig.7].

De préférence, le basculement d'une source à l'autre se fait de manière automatique, c'est-à-dire sans intervention d'un opérateur. Lorsque la quantité de précurseur dans le récipient 1 est inférieure ou égale à un seuil bas prédéterminé, les moyens de basculement sont déplacés dans une deuxième position dans laquelle la phase gazeuse 12 est distribuée dans la canalisation commune 19 à partir de l'autre des deux récipients 1. De préférence, le déplacement des moyens de basculement de la première position vers la deuxième position est déclenché à partir de la mesure d'une grandeur physique représentative de la quantité de précurseur dans le récipient 1 qui peut être choisie parmi : la masse du récipient 1, la pression dans le récipient 1, la température d'une surface extérieure du récipient 1.

Selon une possibilité, on mesure la masse du récipient 1 ce qui revient à mesurer la masse de précurseur restant dans le récipient. De préférence, on mesure la masse brute du récipient contenant le précurseur. La masse nette de précurseur dans le récipient 1 est déduite de la connaissance préalable de la masse du récipient vide, qu'un opérateur peut par exemple saisir dans l'unité de commande au début de l'utilisation du récipient. De préférence, le dispositif comprend des moyens de pesée d'au moins un récipient 1 afin de surveiller l'évolution de la masse du récipient 1. Lorsque que la masse de précurseur devient inférieure à un seuil donné, cela déclenche le déplacement des moyens de basculement.

Selon une autre possibilité, on mesure la pression dans le récipient 1. Si la pression devient inférieure à un seuil donné, cela signifie qu'il n'y a plus assez de phase solide dans le récipient pour maintenir la consigne de pression. Cela déclenche le déplacement des moyens de basculement.

Selon une autre possibilité, on mesure la température d'une surface extérieure du récipient 1, i. e. la température de peau du récipient 1. Si la température dépasse un seuil donné, cela signifie qu'il n'y a plus assez de précurseur dans le récipient et que la température des premiers moyens de chauffage 10 est augmentée afin de maintenir la consigne en pression. Cela déclenche le déplacement des moyens de basculement.

L'intérêt d'un ensemble à plusieurs dispositifs de distribution est de permettre un fonctionnement en continu de l'installation de traitement utilisant le précurseur, malgré l'épuisement d'un récipient. En effet, lorsque le récipient en utilisation atteint le seuil bas, l'autre récipient peut être utilisé pendant que le récipient vide est remplacé par un nouveau récipient plein.

Eventuellement, les moyens de basculement peuvent occuper une position intermédiaire dans laquelle la phase gazeuse 12 est distribuée à partir des deux récipients simultanément, avant le basculement vers l'autre récipient. Cela permet d'éviter les chutes de pression lors de l'ouverture des vannes du deuxième récipient 1 et de vider totalement le premier récipient afin d'augmenter le rendement d'utilisation.

De préférence, les enceintes principales 2 composant l'ensemble de distribution sont agencées côte à côte et on agence une enceinte additionnelle 3 au-dessus des enceintes principales 2. Le volume interne de l'enceinte additionnelle 3 est chauffé à une température supérieure à la température à laquelle le volume des enceintes principales 2 est chauffé, toujours pour respecter le sens de variation de température croissant vers le haut. Des éléments chauffants 50 sont agencés au niveau des passages de parois de chaque enceinte 2 à l'enceinte additionnelle 3.

De préférence, le dispositif comprend au moins une armoire à gaz (en anglais « gas cabinet ») dans laquelle peuvent être installés une ou plusieurs enceintes 2, 3. La source de gaz porteur peut être située dans ou en-dehors de l'armoire en fonction de l'encombrement disponible. De préférence, l'unité de commande 40 peut être agencée dans ou à l'extérieur de l'armoire, soit en étant fixée sur une des parois de l'armoire, soit positionnée à distance de l'armoire. Un système de conduites de gaz est arrangé dans l'armoire. L'armoire peut comprendre des moyens de contrôle et/ou de maintenance du système de conduites de gaz tels que des vannes, des détendeurs, des organes de mesure de pression,... permettant de réaliser les opérations telles que la distribution de gaz, l'ouverture ou la fermeture de certaines conduites ou portions de conduites, la gestion de la pression de gaz, la réalisation de cycles de purge, de tests de fuite,... L'armoire peut comprendre des ouvertures d'entrée de gaz pour une alimentation avec le gaz porteur et une ouverture de sortie de gaz pour la distribution de la phase gazeuse. La conduite de distribution 13 est reliée à l'ouverture de sortie. En fonctionnement, l'armoire à gaz est raccordée à l'installation de traitement par le point de consommation 60. D'autres entrées de gaz peuvent être prévues, notamment pour un gaz de balayage, un gaz étalon ....

### Exemples

Afin de démontrer l'efficacité d'un dispositif selon l'invention, on a procédé à la distribution de MoO₂Cl₂ en tant que précurseur pur à un débit massique de 900 cm³/min standard (i. e. sccm pour « standard cubic centimeters per minute ») et une pression de 650 Torr. La pression de consigne était de 650 Torr. Les premier, deuxième et troisième moyens de chauffage 10, 20, 30 étaient mis en œuvre de façon. Le récipient 1 et les moyens de distribution 13, 14 présentaient un profil de température tel qu'illustré sur [Fig.4].

[Fig.8] montre un changement de débit à 11min de 0 sccm à 900 sccm de MoO2Cl2. Le précurseur est débité pendant 71min, puis le débit est arrêté. [Fig.8] montre également la pression du système et la puissance du premier moyen de chauffage 10. On peut voir que lors du passage de 0 à 900 sccm, la pression du système diminue de 650 Torr (consigne de pression) à 580 Torr. Du fait de la diminution de pression du système, la puissance du premier moyen de chauffage 10 augmente de 2% à 100%. Dû au chauffage du premier moyen de chauffage 10, la pression du système augmente jusqu'à 700 Torr. Au vu de l'augmentation de pression, le chauffage du premier moyen de chauffage est diminué lorsque la pression remonte et se rapproche de la pression de consigne de 650Torr et est arrêté lorsque la pression dépasse la consigne de pression. La pression du système se stabilise ensuite autour de la consigne de pression. On peut voir que l'amplitude des oscillations de pression diminue. Le débit de précurseur est arrêté lorsque la pression du système n'est pas encore stabilisée, mais une variation de pression de 1,5% est atteinte en 71 min.

Le dispositif selon l'invention peut servir à la distribution de précurseurs utilisés dans différentes industries telles que les industries du semi-conducteur, du photovoltaïque, des LED, des écrans plats ou toute autre industrie comme les industries minières, pharmaceutiques, spatiales ou aéronautiques.

## Revendications

1. Dispositif de distribution d'une phase gazeuse d'au moins un précurseur solide, ledit dispositif comprenant :
- un récipient (1) destiné à contenir une phase solide (11) dudit précurseur, le récipient présentant un fond et un sommet,
- un premier moyen de chauffage (10) configuré pour chauffer au moins une partie du récipient (1) et/ou de la phase solide (11) de façon à former une phase gazeuse (12) dudit précurseur dans le récipient (1),
- des moyens de distribution (13, 14) reliés fluidiquement au récipient (1) et configurés pour distribuer la phase gazeuse (12) depuis le récipient (1) vers un point d'utilisation (60),
**caractérisé en ce que** le dispositif comprend une enceinte (2) ayant un volume interne dans lequel sont agencés le récipient (1), le premier moyen de chauffage (10) et les moyens de distribution (13, 14),
l'enceinte (2) présentant une direction axiale (z) sensiblement verticale et orientée dans un sens ascendant, le volume interne de l'enceinte (2) comprenant une zone inférieure (22) et une zone supérieure (21), ledit dispositif comprenant en outre un deuxième moyen de chauffage (20) configuré pour chauffer au moins une partie du volume interne de l'enceinte (2), le deuxième moyen de chauffage (20) comprenant un moyen de circulation d'air (24) configuré pour faire circuler de l'air depuis le deuxième moyen de chauffage (20) en direction du volume interne de l'enceinte (2).

2. Dispositif selon la revendication précédente, **caractérisé en ce que** la zone supérieure (21) est agencée à un niveau supérieur à celui de la zone inférieure (22) en suivant la direction axiale (z), le premier récipient (1) et le premier moyen de chauffage (10) étant agencés dans la zone inférieure (22) et le deuxième moyen de chauffage (20) et les moyens de distribution (13, 14) étant agencés dans la zone supérieure (21).

3. Dispositif selon l'une des revendications précédentes, **caractérisé en ce qu'**il comprend en outre un troisième moyen de chauffage agencé dans la zone inférieure (22) de l'enceinte (2), de préférence autour d'au moins une partie du fond (1a) du récipient (1) ou sous le fond (1a) du récipient (1).

4. Dispositif selon l'une des revendications précédentes, **caractérisé en ce que** le deuxième moyen de chauffage (20) comprend au moins une résistance électrique notamment montée sur une paroi de l'enceinte (2) ou à proximité de ladite paroi.

5. Dispositif selon l'une des revendications précédentes, **caractérisé en ce que** le dispositif comprenant au moins un capteur de pression (PC) configuré pour mesurer la pression à l'intérieur du récipient (1) et une unité de commande (40) reliée au capteur de pression (PC) et au premier moyen de chauffage (10), l'unité de commande (40) étant notamment configurée pour réguler et/ou ajuster la puissance de chauffage délivrée par le premier moyen de chauffage (10) en fonction de la pression mesurée par le capteur de pression (PC).

6. Dispositif selon l'une des revendications précédentes, **caractérisé en ce qu'**il comprend en outre une source de gaz porteur (4), une conduite d'alimentation (15) reliant fluidiquement la source de gaz porteur (4) à une entrée (16) du récipient (1) et des moyens de circulation (41, 42) du gaz porteur (4) dans le récipient (1), lesdits moyens de circulation (41, 42) du gaz porteur étant configurés pour faire circuler le gaz porteur (4) entre l'entrée (16) et une sortie (17) du récipient (1) de sorte que les moyens de distribution (13, 14) distribue un mélange gazeux comprenant la phase gazeuse (12) et le gaz porteur (4) depuis le récipient (1), lesdits moyens de circulation (41, 42) du gaz porteur étant notamment configurés pour contrôler le débit de gaz porteur (4) circulant dans le récipient (1) et/ou pour contrôler la pression dans le récipient (1).

7. Dispositif selon l'une des revendications précédentes, **caractérisé en ce que** le dispositif comprend au moins un capteur de température (TC) configuré pour mesurer la température d'une surface extérieure du récipient (1) et/ou pour mesurer la température à l'intérieur de l'enceinte, et une unité de commande (40) reliée au capteur de température (TC) et au premier moyen de chauffage (11), l'unité de commande (40) étant notamment configurée pour faire varier la puissance de chauffage délivrée par le premier moyen de chauffage (10) en fonction de la température mesurée par le capteur de température (TC).

8. Dispositif selon l'une des revendications précédentes, **caractérisé en ce que** les moyens de distribution (13, 14) comprennent au moins une conduite de distribution (13) traversant une première paroi (52) de l'enceinte (2), un élément chauffant (50) formant un manchon autour d'au moins une partie de la conduite de distribution (13) et s'étendant de part et d'autre de ladite première paroi (52).

9. Ensemble de distribution comprenant au moins deux dispositifs de distribution tels que définis par l'une des revendications 1 à 8, chaque dispositif comprenant une enceinte (2), un récipient (1) et des moyens de distribution (13, 14) respectifs reliés fluidiquement à une canalisation commune (19), ledit ensemble comprenant des moyens de basculement configurés pour occuper une première position dans laquelle la phase gazeuse (12) est distribuée dans la canalisation commune (19) à partir de l'un des deux récipients et, lorsque la quantité de précurseur dans le récipient (1) est inférieure ou égale à un seuil bas prédéterminé, pour occuper une deuxième position dans laquelle la phase gazeuse (12) est distribuée dans la canalisation commune (19) à partir de l'autre des deux récipients (1) ou pour occuper une position intermédiaire dans laquelle la phase gazeuse (12) est distribuée à partir des deux récipients simultanément, les moyens de basculement étant reliés à un organe de mesure d'une grandeur physique représentative de la quantité de précurseur dans le récipient (1) choisie parmi : la masse du récipient (1), la pression dans le récipient (1), la température d'une surface extérieure du récipient (1), le déplacement des moyens de basculement de la première position à la deuxième position étant déterminé en fonction de la mesure de ladite grandeur physique.

10. Installation de traitement, en particulier de dépôt chimique en phase vapeur, comprenant une chambre de traitement dans laquelle un ou plusieurs substrats à traiter sont installés, la chambre de traitement comportant des moyens d'introduction d'au moins une phase gazeuse (12) d'un précurseur solide dans la chambre de traitement, **caractérisée en ce que** les moyens d'introduction sont reliés fluidiquement aux moyens de distribution (13, 14) d'un dispositif tel que défini par l'une des revendications 1 à 8 ou d'un ensemble tel que défini par la revendication 9.

11. Procédé de distribution d'une phase gazeuse d'au moins un précurseur solide comprenant les étapes suivantes :
a) agencer une phase solide (11) dudit précurseur dans un récipient (1),
b) chauffer au moins une partie du récipient (1) et/ou de la phase solide (11) avec un premier moyen de chauffage (10) de façon à former une phase gazeuse (12) dudit précurseur dans le récipient (1),
c) distribuer la phase gazeuse (12) depuis le récipient (1) par des moyens de distribution (13, 14) reliés fluidiquement au récipient (1), le procédé comprenant en outre les étapes de :
d) agencer le récipient (1), le premier moyen de chauffage (10) et les moyens de distribution (13, 14) dans un volume interne d'une enceinte (2), l'enceinte (2) ayant une direction axiale (z) sensiblement verticale et orientée dans un sens ascendant, le volume interne de l'enceinte (2) comprenant une zone inférieure (22) et une zone supérieure (21),
e) chauffer au moins une partie du volume interne de l'enceinte (2) avec un deuxième moyen de chauffage (20), le deuxième moyen de chauffage (20) comprenant un moyen de circulation d'air (24) configuré pour faire circuler de l'air depuis le deuxième moyen de chauffage (20) en direction du volume interne de l'enceinte (2).

## Patentansprüche

1. Vorrichtung zur Abgabe einer Gasphase mindestens eines festen Vorläufers, die Vorrichtung umfassend:
- einen Behälter (1), der dazu bestimmt ist, eine feste Phase (11) des Vorläufers zu enthalten, wobei der Behälter einen Boden und einen Kopf aufweist,
- ein erstes Heizmittel (10), das dazu ausgestaltet ist, mindestens einen Teil des Behälters (1) und/oder der festen Phase (11) zu erhitzen, so dass eine Gasphase (12) des Vorläufers in dem Behälter (1) gebildet wird,
- Abgabemittel (13, 14), die fluidisch mit dem Behälter (1) verbunden sind und dazu ausgestaltet sind, die Gasphase (12) von dem Behälter (1) aus zu einer Verwendungsstelle (60) abzugeben,
**dadurch gekennzeichnet, dass** die Vorrichtung eine Einhausung (2) umfasst, die ein Innenvolumen besitzt, in dem der Behälter (1), das erste Heizmittel (10) und die Abgabemittel (13, 14) angeordnet sind, wobei die Einhausung (2) eine im Wesentlichen vertikale und aufsteigend ausgerichtete axiale Richtung (z) aufweist, wobei das Innenvolumen der Einhausung (2) einen unteren Bereich (22) und einen oberen Bereich (21) umfasst, wobei die Vorrichtung ferner ein zweites Heizmittel (20) umfasst, das dazu ausgestaltet ist, mindestens einen Teil des Innenvolumens der Einhausung (2) zu erhitzen, wobei das zweite Heizmittel (20) ein Luftzirkulationsmittel (24) umfasst, das dazu ausgestaltet ist, Luft von dem zweiten Heizmittel (20) aus in Richtung des Innenvolumens der Einhausung (2) zirkulieren zu lassen.

2. Vorrichtung nach dem vorhergehenden Anspruch, **dadurch gekennzeichnet, dass** der obere Bereich (21) auf einer höheren Ebene als der untere Bereich (22) entlang der axialen Richtung (z) angeordnet ist, wobei der erste Behälter (1) und das erste Heizmittel (10) in dem unteren Bereich (22) angeordnet sind und wobei das zweite Heizmittel (20) und die Abgabemittel (13, 14) in dem oberen Bereich (21) angeordnet sind.

3. Vorrichtung nach einem der vorhergehenden Ansprüche, **dadurch gekennzeichnet, dass** sie ferner ein drittes Heizmittel umfasst, das in dem unteren Bereich (22) der Einhausung (2) angeordnet ist, bevorzugt um mindestens einen Teil des Bodens (1a) des Behälters (1) herum oder unter dem Boden (1a) des Behälters (1).

4. Vorrichtung nach einem der vorhergehenden Ansprüche, **dadurch gekennzeichnet, dass** das zweite Heizmittel (20) mindestens einen elektrischen Widerstand umfasst, der insbesondere an einer Wand der Einhausung (2) oder in der Nähe der Wand angebracht ist.

5. Vorrichtung nach einem der vorhergehenden Ansprüche, **dadurch gekennzeichnet, dass** die Vorrichtung mindestens einen Drucksensor (PC) umfasst, der dazu ausgestaltet ist, den Druck im Inneren des Behälters (1) zu messen, und eine Steuerungseinheit (40), die mit dem Drucksensor (PC) und mit dem ersten Heizmittel (10) verbunden ist, wobei die Steuerungseinheit (40) insbesondere dazu ausgestaltet ist, die von dem ersten Heizmittel (10) ausgegebene Heizleistung in Abhängigkeit von dem von dem Drucksensor (PC) gemessenen Druck zu regulieren und/oder anzupassen.

6. Vorrichtung nach einem der vorhergehenden Ansprüche, **dadurch gekennzeichnet, dass** sie ferner eine Quelle für Trägergas (4), eine Versorgungsleitung (15), die die Quelle für Trägergas (4) fluidisch mit einem Einlass (16) des Behälters (1) verbindet, und Zirkulationsmittel (41, 42) für das Trägergas (4) in dem Behälter (1) umfasst, wobei die Zirkulationsmittel (41, 42) für das Trägergas dazu ausgestaltet sind, das Trägergas (4) zwischen dem Einlass (16) und einem Auslass (17) des Behälters (1) zirkulieren zu lassen, so dass die Abgabemittel (13, 14) ein Gasgemisch, das die Gasphase (12) und das Trägergas (4) umfasst, von dem Behälter (1) aus abgeben, wobei die Zirkulationsmittel (41, 42) für das Trägergas insbesondere dazu ausgestaltet sind, den Volumenstrom des Trägergases (4), das in dem Behälter (1) zirkuliert, zu steuern und/oder den Druck in dem Behälter (1) zu steuern.

7. Vorrichtung nach einem der vorhergehenden Ansprüche, **dadurch gekennzeichnet, dass** die Vorrichtung mindestens einen Temperatursensor (TC) umfasst, der dazu ausgestaltet ist, die Temperatur einer Außenfläche des Behälters (1) zu messen und/oder die Temperatur im Inneren der Einhausung zu messen, und eine Steuerungseinheit (40), die mit dem Temperatursensor (TC) und mit dem ersten Heizmittel (11) verbunden ist, wobei die Steuerungseinheit (40) insbesondere dazu ausgestaltet ist, die von dem ersten Heizmittel (10) ausgegebene Heizleistung in Abhängigkeit von dem von der Temperatursensor (TC) gemessenen Temperatur variieren zu lassen.

8. Vorrichtung nach einem der vorhergehenden Ansprüche, **dadurch gekennzeichnet, dass** die Abgabemittel (13, 14) mindestens eine Abgabeleitung (13) umfassen, die eine erste Wand (52) der Einhausung (2) durchdringt, wobei ein Heizelement (50) eine Hülse um mindestens einen Teil der Abgabeleitung (13) bildet und sich beidseits der ersten Wand (52) erstreckt.

9. Abgabeanordnung, umfassend mindestens zwei Vorrichtungen zur Abgabe wie in einem der Ansprüche 1 bis 8 definiert, jede Vorrichtung umfassend eine Einhausung (2), einen Behälter (1) und jeweilige Abgabemittel (13, 14), die fluidisch mit einer gemeinsamen Leitung (19) verbunden sind, die Anordnung umfassend Umschaltmittel, die dazu ausgestaltet sind, eine erste Stellung einzunehmen, in der die Gasphase (12) ausgehend von dem einen der beiden Behälter in die gemeinsame Leitung (19) abgegeben wird, und, wenn die Vorläufermenge in dem Behälter (1) kleiner oder gleich einem vorbestimmten unteren Schwellenwert ist, eine zweite Stellung einzunehmen, in der die Gasphase (12) ausgehend von dem anderen der beiden Behälter (1) in die gemeinsame Leitung (19) abgegeben wird, oder eine Zwischenstellung einzunehmen, in der die Gasphase (12) ausgehend von den beiden Behältern gleichzeitig abgegeben wird, wobei die Umschaltmittel mit einem Organ zum Messen einer physikalischen Größe verbunden sind, die für die Vorläufermenge in dem Behälter (1) repräsentativ ist und ausgewählt ist unter: der Masse des Behälters (1), dem Druck in dem Behälter (1), der Temperatur einer Außenfläche des Behälters (1), wobei die Verlagerung der Umschaltmittel aus der ersten Stellung in die zweite Stellung in Abhängigkeit von der Messung der physikalischen Größe bestimmt wird.

10. Anlage zur Behandlung, insbesondere zur chemischen Gasphasenabscheidung, umfassend eine Behandlungskammer, in der ein oder mehrere zu behandelnde Substrate eingerichtet sind, wobei die Behandlungskammer Mittel zum Einleiten mindestens einer Gasphase (12) eines festen Vorläufers in die Behandlungskammer umfasst, **dadurch gekennzeichnet, dass** die Mittel zum Einleiten fluidisch mit den Abgabemitteln (13, 14) einer Vorrichtung wie in einem der Ansprüche 1 bis 8 definiert oder einer Anordnung wie in Anspruch 9 definiert verbunden sind.

11. Verfahren zur Abgabe einer Gasphase mindestens eines festen Vorläufers, umfassend die folgenden Schritte:
a) Anordnen einer festen Phase (11) des Vorläufers in einem Behälter (1),
b) Erhitzen mindestens eines Teil des Behälters (1) und/oder der festen Phase (11) mit einem ersten Heizmittel (10), so dass eine Gasphase (12) des Vorläufers in dem Behälter (1) gebildet wird,
c) Abgeben der Gasphase (12) von dem Behälter (1) aus durch Abgabemittel (13, 14), die fluidisch mit dem Behälter (1) verbunden sind,
wobei das Verfahren ferner die Schritte umfasst:
d) Anordnen des Behälters (1), des ersten Heizmittels (10) und der Abgabemittel (13, 14) in einem Innenvolumen einer Einhausung (2), wobei die Einhausung (2) eine im Wesentlichen vertikale und aufsteigend ausgerichtete axiale Richtung (z) aufweist, wobei das Innenvolumen der Einhausung (2) einen unteren Bereich (22) und einen oberen Bereich (21) umfasst,
e) Erhitzen mindestens eines Teils des Innenvolumens der Einhausung (2) mit einem zweiten Heizmittel (20), wobei das zweite Heizmittel (20) ein Luftzirkulationsmittel (24) umfasst, das dazu ausgestaltet ist, Luft von dem zweiten Heizmittel (20) aus in Richtung des Innenvolumens der Einhausung (2) zirkulieren zu lasen.

## Claims

1. Device for distributing a gas phase of at least one solid precursor, said device comprising:
- a vessel (1) intended to contain a solid phase (11) of said precursor, the vessel having a bottom and a top,
- a first heating means (10) configured to heat at least a part of the vessel (1) and/or of the solid phase (11) so as to form a gas phase (12) of said precursor in the vessel (1),
- distribution means (13, 14) fluidically connected to the vessel (1) and configured to distribute the gas phase (12) from the vessel (1) to a point of use (60),
**characterized in that** the device comprises an enclosure (2) having an internal volume in which the vessel (1), the first heating means (10) and the distribution means (13, 14) are arranged, the enclosure (2) having a substantially vertical axial direction (z) oriented in an upward direction, the internal volume of the enclosure (2) comprising a lower zone (22) and an upper zone (21), said device further comprising a second heating means (20) configured to heat at least a part of the internal volume of the enclosure (2), the second heating means (20) comprising an air circulation means (24) configured to circulate air from the second heating means (20) in the direction of the internal volume of the enclosure (2).

2. Device according to the preceding claim, **characterized in that** the upper zone (21) is arranged at a higher level than that of the lower zone (22) in the axial direction (z), the first vessel (1) and the first heating means (10) being arranged in the lower zone (22) and the second heating means (20) and the distribution means (13, 14) being arranged in the upper zone (21).

3. Device according to either of the preceding claims, **characterized in that** it further comprises a third heating means arranged in the lower zone (22) of the enclosure (2), preferably around at least a part of the bottom (1a) of the vessel (1) or under the bottom (1a) of the vessel (1).

4. Device according to one of the preceding claims, **characterized in that** the second heating means (20) comprises at least one electrical resistor notably mounted on a wall of the enclosure (2) or in the vicinity of said wall.

5. Device according to one of the preceding claims, **characterized in that** the device comprises at least one pressure sensor (PC) configured to measure the pressure inside the vessel (1), and a control unit (40) connected to the pressure sensor (PC) and to the first heating means (10), the control unit (40) notably being configured to regulate and/or adjust the heating power delivered by the first heating means (10) as a function of the pressure measured by the pressure sensor (PC).

6. Device according to one of the preceding claims, **characterized in that** it further comprises a source of carrier gas (4), a supply duct (15) fluidically connecting the source of carrier gas (4) to an inlet (16) of the vessel (1) and means (41, 42) for circulating the carrier gas (4) in the vessel (1), said means (41, 42) for circulating the carrier gas being configured to circulate the carrier gas (4) between the inlet (16) and an outlet (17) of the vessel (1) such that the distribution means (13, 14) distribute a gas mixture comprising the gas phase (12) and the carrier gas (4) from the vessel (1), said means (41, 42) for circulating the carrier gas notably being configured to control the flow rate of carrier gas (4) circulating in the vessel (1) and/or to control the pressure in the vessel (1).

7. Device according to one of the preceding claims, **characterized in that** the device comprises at least one temperature sensor (TC) configured to measure the temperature of an outer surface of the vessel (1) and/or to measure the temperature inside the enclosure, and a control unit (40) connected to the temperature sensor (TC) and to the first heating means (11), the control unit (40) notably being configured to vary the heating power delivered by the first heating means (10) as a function of the temperature measured by the temperature sensor (TC).

8. Device according to one of the preceding claims, **characterized in that** the distribution means (13, 14) comprise at least one distribution duct (13) passing through a first wall (52) of the enclosure (2), a heating element (50) forming a sleeve around at least a part of the distribution duct (13) and extending on either side of said first wall (52).

9. Distribution assembly comprising at least two distribution devices as defined by one of Claims 1 to 8, each device comprising an enclosure (2), a vessel (1) and respective distribution means (13, 14) fluidically connected to a common pipe (19), said assembly comprising switching means configured to occupy a first position in which the gas phase (12) is distributed into the common pipe (19) from one of the two vessels and, when the quantity of precursor in the vessel (1) is lower than or equal to a predetermined low threshold, to occupy a second position in which the gas phase (12) is distributed into the common pipe (19) from the other of the two vessels (1) or to occupy an intermediate position in which the gas phase (12) is distributed from both vessels simultaneously, the switching means being connected to a member for measuring a physical quantity representative of the quantity of precursor in the vessel (1), selected from among: the mass of the vessel (1), the pressure in the vessel (1), the temperature of an outer surface of the vessel (1), the movement of the switching means from the first position to the second position being determined as a function of the measurement of said physical quantity.

10. Treatment installation, in particular a chemical vapour deposition installation, comprising a treatment chamber in which one or more substrates to be treated are installed, the treatment chamber comprising means for introducing at least one gas phase (12) of a solid precursor into the treatment chamber, **characterized in that** the introduction means are fluidically connected to the distribution means (13, 14) of a device as defined by one of Claims 1 to 8 or of an assembly as defined by Claim 9.

11. Method for distributing a gas phase of at least one solid precursor, comprising the following steps:
a) arranging a solid phase (11) of said precursor in a vessel (1),
b) heating at least a part of the vessel (1) and/or of the solid phase (11) with a first heating means (10) so as to form a gas phase (12) of said precursor in the vessel (1),
c) distributing the gas phase (12) from the vessel (1) by way of distribution means (13, 14) that are fluidically connected to the vessel (1),
the method further comprising the steps of:
d) arranging the vessel (1), the first heating means (10) and the distribution means (13, 14) in an internal volume of an enclosure (2), the enclosure (2) having a substantially vertical axial direction (z) oriented in an upward direction, the internal volume of the enclosure (2) comprising a lower zone (22) and an upper zone (21),
e) heating at least a part of the internal volume of the enclosure (2) with a second heating means (20), the second heating means (20) comprising an air circulation means (24) configured to circulate air from the second heating means (20) in the direction of the internal volume of the enclosure (2).
